(19) Europäisches Patentamt
European Patent Office
Office européen des brevets

(11) **EP 2 850 556 B1**

(12) **EUROPEAN PATENT SPECIFICATION**

(45) Date of publication and mention
of the grant of the patent:
**18.03.2020 Bulletin 2020/12**

(21) Application number: **12877040.1**

(22) Date of filing: **14.05.2012**

(51) Int Cl.:
**G01V 99/00** [(2009.01)]

(86) International application number:
**PCT/US2012/037778**

(87) International publication number:
**WO 2013/172813 (21.11.2013 Gazette 2013/47)**

(54) **MODELING STRESS AROUND A WELLBORE**

MODELLIERUNG DER BELASTUNG RUND UM EIN BOHRLOCH

MODÉLISATION DE CONTRAINTES AUTOUR D'UN TROU DE FORAGE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**25.03.2015 Bulletin 2015/13**

(73) Proprietor: **Landmark Graphics Corporation Houston, TX 77042-3021 (US)**

(72) Inventor: **BAI, Mao Houston, Texas 77083 (US)**

(74) Representative: **Hoffmann Eitle Patent- und Rechtsanwälte PartmbB Arabellastraße 30 81925 München (DE)**

(56) References cited:
US-A1- 2005 209 912    US-A1- 2008 319 675
US-A1- 2011 283 807    US-B2- 7 181 380
US-B2- 7 181 380

- **Milton Bock Enderlin: "A method for evaluating the effects of stresses and rock strength on fluid flow along the surfaces of mechanical discontinuities in low permeability rocks", , 1 December 2010 (2010-12-01), XP055279780, ISBN: 978-1-124-48083-1 Retrieved from the Internet: URL:https://www.google.nl/url?sa=t&rct=j&q =&esrc=s&source=web&cd=3&ved=0ahUKEwj- yLTX 4Z3NAhVl8ywKHb2XDA0QFggwMAI&url=https:/ /re pository.tcu.edu/bitstream/handle/11609911 7/4225/Enderlin.pdf?sequence=1&usg=AFQjCN E i77RK78kuNYbCRGnuQW1YJjn2dw&bvm=bv.12 40881 55,d.bGg [retrieved on 2016-06-10]**
- **Joseph Batir ET AL: "PRELIMINARY MODEL OF FRACTURE AND STRESS STATE IN THE HELLISHEIDI GEOTHERMAL FIELD, HENGILL VOLCANIC SYSTEM, ICELAND", Thirty-Seventh Workshop on Geothermal Reservoir Engineering, 1 February 2012 (2012-02-01), XP055278640, Retrieved from the Internet: URL:https://pangea.stanford.edu/ERE/pdf/IG Astandard/SGW/2012/Batir.pdf [retrieved on 2016-06-08]**
- **Milton Enderlin ET AL: "PS Predicting Fracability in Shale Reservoirs*", , 10 April 2011 (2011-04-10), page 13, XP055278884, Retrieved from the Internet: URL:http://www.searchanddiscovery.com/docu ments/2011/40783enderlin/ndx_enderlin.pdf**

- **Mesut Pervizpour: "Performance Evaluation of Constructed Facilities", , 1 November 2004 (2004-11-01), XP055279070, Retrieved from the Internet: URL:http://www.lehigh.edu/~mepa/f/ENGR-627 -Lect4.pdf [retrieved on 2016-06-09]**

**Description**

TECHNICAL BACKGROUND

This disclosure relates to modeling stress around a wellbore.

BACKGROUND

In the petroleum industry, drilling from a terranean surface to a target depth may be a complex process that requires a thorough knowledge of the environments and properties of the reservoir formation, which include, but are not limited to, in-situ stress regimes, pore pressure, formation rock strength, and others characteristics. Such characteristics may impact wellbore mechanical stability, which may be described by a geomechanical model including the above-described characteristics, and possibly others.

There are many ways in establishing a geomechanical model for drilling and wellbore operation optimization. In some instances, understanding local and regional stress regimes around the wellbore may be helpful in developing and/or calibrating the geomechanical model to optimize drilling or other wellbore operations with regard to achieving efficient well support and maximized hole stability. One conventional method for determining the stress field around wellbore with the related geological faulting mechanisms is the stress polygon method. This method typically invokes the concept of non-cohesive frictional fault sliding. Frictional faults, however, are usually composed of cohesive rocks rather than non-cohesive materials, such as sands, so that the cohesive frictional faults may prevail in the reservoir conditions.

US 7,181,380 B2 discloses a system, and process for optimal selection of hydrocarbon well completion type and design.

The master thesis "A Method for Evaluating the Effects of Stresses and Rock Strength on Fluid Flow along the Surfaces of Mechanical Discontinuities in Low Permeability Rocks" by Milton Bock Enderlin, Texas Christian University, December 2010 discloses showing unconfined stresses with the stress polygon method.

SUMMARY OF THE INVENTION

According to a first aspect of the present invention, there is provided a method performed with a computing system for modeling stress around a wellbore, the method comprising: calibrating a geomechanical model that comprises geologic data associated with a subterranean zone based on a stress polygon method and an unconfined compressive strength (UCS) associated with the subterranean zone; generating an output of a predicated stress state of the subterranean zone based on the calibrated geomechanical model; initiating formation of the wellbore through or proximate to the subterranean zone accounting for the calibrated geomechanical model and the predicted stress state of the subterranean zone; wireline logging the wellbore during formation of the wellbore; and revising the geologic data based on the logging; and re-calibrating the geomechanical model based on the revised geologic data.

According to a second aspect of the present invention, there is provided a computer storage medium encoded with a computer program, the program comprising instructions that when executed by one or more computers cause the one or more computers to perform operations comprising: calibrating a geomechanical model that comprises geologic data associated with a subterranean zone based on a stress polygon method and an unconfined compressive strength (UCS) associated with the subterranean zone; generating an output of a predicated stress state of the subterranean zone based on the calibrated geomechanical model; initiating formation of a wellbore through or proximate to the subterranean zone accounting for the calibrated geomechanical model and the predicted stress state of the subterranean zone; wireline logging the wellbore during formation of the wellbore; and revising the geologic data based on the logging; and re-calibrating the geomechanical model based on the revised geologic data.

According to a third aspect of the present invention there is provided a system of one or more computers configured to perform operations comprising: calibrating a geomechanical model that comprises geologic data associated with a subterranean zone based on a stress polygon method and an unconfined compressive strength (UCS) associated with the subterranean zone; generating an output of a predicated stress state of the subterranean zone based on the calibrated geomechanical model; initiating formation of a wellbore (102) through or proximate to the subterranean zone accounting for the calibrated geomechanical model and the predicted stress state of the subterranean zone; wireline logging the wellbore during formation of the wellbore; and revising the geologic data based on the logging; and re-calibrating the geomechanical model based on the revised geologic data.

DESCRIPTION OF DRAWINGS

For a better understanding of the present invention, reference is now made, by way of example only, to the following drawings, in which:

FIG. 1 illustrates an example downhole system including an example embodiment of a wellbore stress engine;
FIG. 2A is a graphical representation of an example wellbore log;
FIG. 2B illustrates an example method for modeling stress around a wellbore;
FIG. 2C illustrates an example geomechanical model;
FIGS. 3A-3C are graphical representations of normal stress and shear stress applied to a portion of an example subterranean zone and wellbore failure due to stress concentration;
FIGS. 4A-4B are graphical representations of pressure applied to a wellbore in an example subterranean zone;
FIGS. 5A-5B are example graphs of maximum stress vs. minimum stress for frictional sliding and Mohr-Coulomb solutions that have example cohesion values;
FIG. 6 is an example graph of maximum stress vs. minimum stress for stress regimes under three faulting mechanisms according to the stress polygon method;
FIGS. 7A-7B are example graphs comparing Anderson's and Mohr-Coulomb solutions of maximum stress vs. minimum stress for stress regimes under three faulting mechanisms according to the stress polygon method at different example cohesion values;
FIG. 8 is an example graph comparing Anderson's and Mohr-Coulomb solutions of maximum stress vs. minimum stress for stress regimes under three faulting mechanisms according to the stress polygon method for an example geologic formation;
FIG. 9 is an example graph of effective stress ratio vs. friction coefficient for stress regimes;
FIGS. 10A-10B are example graphs of maximum stress vs. minimum stress for stress regimes under three faulting mechanisms according to the stress polygon method under bounds either as maximum stress or as minimum stress;
FIG. 11 is an example graph of internal friction angle vs. friction coefficient for various example formations according to observed and calculated values; and
FIG. 12 is an example graph of maximum stress vs. minimum stress under either no cohesion or with cohesion.

DETAILED DESCRIPTION

In one general embodiment, techniques for modeling stress around a wellbore include calibrating a geomechanical model that comprises geologic data associated with a subterranean zone based on a stress polygon method; and generating an output of a predicated stress state of the subterranean zone based on the calibrated geomechanical model.

In a first aspect combinable with the general embodiment, calibrating the geomechanical model based on the stress polygon method includes accounting for an unconfined compressive strength (UCS) associated with the subterranean zone.

A second aspect combinable with any of the previous aspects includes initiating formation of a wellbore through or proximate to the subterranean zone.

A third aspect combinable with any of the previous aspects includes wireline logging the wellbore during formation of the wellbore.

A fourth aspect combinable with any of the previous aspects includes revising the geologic data based on the logging.

A fifth aspect combinable with any of the previous aspects includes re-calibrating the geomechanical model based on the revised geologic data.

A sixth aspect combinable with any of the previous aspects includes predicting, during formation of the wellbore, a revised stress state of the subterranean zone using the updated geomechanical model based on the revised geologic data.

A seventh aspect combinable with any of the previous aspects includes receiving an identification of the geologic data associated with the subterranean zone.

An eighth aspect combinable with any of the previous aspects includes generating, based on the identified geologic data, the geomechanical model of the subterranean zone.

In a ninth aspect combinable with any of the previous aspects, the identified geologic data comprises at least one of historical geologic data associated with the subterranean zone, or geologic data determined by a minifrac test.

A tenth aspect combinable with any of the previous aspects includes completing the formation of the wellbore to a specified depth.

An eleventh aspect combinable with any of the previous aspects includes subsequent to completing the formation of the wellbore, logging the completed wellbore.

A twelfth aspect combinable with any of the previous aspects includes revising the geologic data based on the logging of the competed wellbore.

A thirteenth aspect combinable with any of the previous aspects includes re-calibrating the geomechanical model based on the revised geologic data.

In a fourteenth aspect combinable with any of the previous aspects, the stress state of the subterranean zone comprises a maximum horizontal stress of the subterranean zone.

In a fifteenth aspect combinable with any of the previous aspects, calibrating the geomechanical model based on the stress polygon method and the UCS associated with the subterranean zone includes shifting a polygon defined by the stress polygon method based on the UCS and a friction coefficient associated with the subterranean zone.

A sixteenth aspect combinable with any of the previous aspects includes adjusting a weight of a drilling fluid based on the predicted stress state of the subterranean zone.

In a seventeenth aspect combinable with any of the previous aspects, the geologic data comprises one or more of gamma ray data, resistivity data, or sonic data, associated with the subterranean zone.

An eighteenth aspect combinable with any of the previous aspects further includes providing the output of the predicted stress state through a GUI of a computing system.

Various embodiments of a wellbore stress engine according to the present disclosure may include one or more of the following features. For example, the wellbore stress engine may provide a derivation of near-wellbore stress regimes from both non-cohesive and cohesive frictional faulting mechanisms. Further, the wellbore stress engine may identify and utilize correlations between the non-cohesive stress polygon method from the Anderson's sliding faulting mechanism and the cohesive stress polygon method from the cohesive Mohr-Coulomb failure criterion. For example, while the Mohr-Coulomb method may improve over the Anderson sliding faulting method with respect to defining more sensible stress polygon regions, the wellbore stress engine may utilize a new stress polygon method that leads to a shift of stress polygon to the upper left corner in comparison with the stress polygon method suggested by Zoback (2007). The wellbore stress engine may thus simulate the stress regimes for a more representative reservoir formation. As a further example, the wellbore stress engine may account for the impact of rock cohesion by, for example, including the cohesion effect in the formulation of the stress polygon method.

These general and specific aspects can be implemented using a device, system or method, or any combinations of devices, systems, or methods. For example, a system of one or more computers can be configured to perform particular actions by virtue of having software, firmware, hardware, or a combination of them installed on the system that in operation causes or cause the system to perform the actions. One or more computer programs can be configured to perform particular actions by virtue of including instructions that, when executed by data processing apparatus, cause the apparatus to perform the actions. The details of one or more implementations are set forth in the accompanying drawings and the description below. Other features, objects, and advantages will be apparent from the description and drawings, and from the claims.

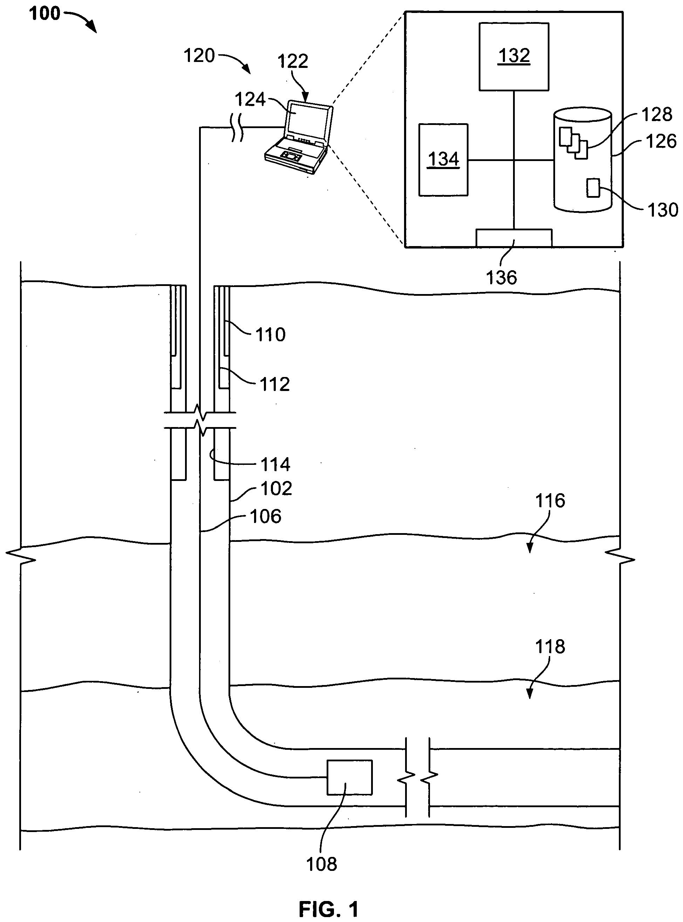

FIG. 1 illustrates an example downhole system 100 including an example embodiment of a wellbore stress engine 132. In some example embodiments, and described in more detail below, the wellbore stress engine 132 may generate, calibrate, re-calibrate, and otherwise manage a geomechanical model of a subterranean zone based on collected geologic data of the subterranean zone and a stress polygon method. In some embodiments, the wellbore stress engine 132 may calibrate and/or re-calibrate the geomechanical model based on the stress polygon model that may account for the impact of unconfined compressive strength (UCS) of the subterranean zone. Such a calibrated geomechanical model may, in some embodiments, allow a well operator to determine and/or predict a stability of a wellbore being formed (or having been formed) in the subterranean zone. For instance, the well operator, driller, or well owner, for example, may determine a stress regime that includes a maximum horizontal stress of the wellbore based on the calibrated geomechanical model through execution of the wellbore stress engine 132.

FIG. 1 illustrates a portion of an example embodiment of the downhole system 100 according to the present disclosure. Generally, the downhole system 100 accesses one or more subterranean formations 116 and/or 118, and facilitates production of any hydrocarbons located in such subterranean formations 116 and/or 118 (or other subterranean formations or zones).

As illustrated in FIG. 1, the downhole system 100 includes a wellbore 102 formed with a drilling assembly (not shown) deployed on a terranean surface 104. The drilling assembly may be used to form a vertical wellbore portion extending from the terranean surface 104 and through the one or more subterranean formations 116, 118 in the Earth. One or more wellbore casings, such as a conductor casing 110, an intermediate casing 112, and a production casing 114 may be installed in at least a portion of the vertical portion of the wellbore 102. Alternatively, in some embodiments, one or more of the casings 110, 112, and 114 may not be installed (e.g., an open hole completion).

In some embodiments, the drilling assembly may be deployed on a body of water rather than the terranean surface 104. For instance, in some embodiments, the terranean surface 104 may be an ocean, gulf, sea, or any other body of water under which hydrocarbon-bearing formations may be found. In short, reference to the terranean surface 104 includes both land and water surfaces and contemplates forming and/or developing one or more wellbores 102 from either or both locations.

FIG. 1 generally illustrates the wellbore 102 already formed (e.g., post-drilling) to a specified depth. The drilling assembly that forms the wellbore 102, however, may be any appropriate assembly or drilling rig used to form wellbores or boreholes in the Earth. In some embodiments, the drilling assembly may use rotary drilling equipment to form such wellbores. Rotary drilling equipment is known and may consist of a drill string and a bottom hole assembly. In some embodiments, the drilling assembly may consist of a rotary drilling rig. Rotating equipment on such a rotary drilling rig may consist of components that serve to rotate a drill bit, which in turn forms the wellbore 102 deeper and deeper into the ground. Rotating equipment consists of a number of components (not shown), which contribute to transferring power from a prime mover to the drill bit itself. The prime mover supplies power to a rotary table, or top direct drive system, which in turn supplies rotational power to the drill string. The drill string is typically attached to the drill bit within the bottom hole assembly. A swivel, which is attached to hoisting equipment, carries much, if not all of, the weight of the drill string, but may allow it to rotate freely.

A drill bit is typically located within or attached to the bottom hole assembly, which is located at a downhole end of the drill string. The drill bit is primarily responsible for making contact with the material (*e.g.,* rock) within the one or more geological formations and drilling through such material. The four most common types of drill bits consist of: delayed or dragged bits, steel to rotary bits, polycrystalline diamond compact bits, and diamond bits. Regardless of the particular drill bits selected, continuous removal of the "cuttings" is essential to rotary drilling.

The circulating system of a rotary drilling operation may be an additional component of the drilling assembly. Generally, the circulating system has a number of main objectives, including cooling and lubricating the drill bit, removing the cuttings from the drill bit and the wellbore, and coating the walls of the wellbore with a mud type cake. The circulating system consists of drilling fluid (*e.g.,* air, foam, water, water-based chemicals, and other fluids), which is circulated down through the wellbore 102 throughout the drilling process. Typically, the components of the circulating system include drilling fluid pumps, compressors, related plumbing fixtures, and specialty injectors for the addition of additives to the drilling fluid. In some embodiments, such as, for example, during a horizontal or directional drilling process, downhole motors may be used in conjunction with or in the bottom hole assembly. Such a downhole motor may be a mud motor with a turbine arrangement, or a progressive cavity arrangement, such as a Moineau motor. These motors receive the drilling fluid through the drill string and rotate to drive the drill bit or change directions in the drilling operation.

In many rotary drilling operations, the drilling fluid is pumped down the drill string and out through ports or jets in the drill bit. The fluid then flows up toward the surface 104 within an annular space (*i.e.,* an annulus) between the wellbore 102 and the drill string, carrying cuttings in suspension to the surface. The drilling fluid, much like the drill bit, may be chosen depending on the type of geological conditions found under the terranean surface 104, such as, for example, a pressure (*e.g.,* pore pressure) of the subterranean formation(s).

As illustrated in FIG. 1, subsequent to or during formation (*e.g.,* drilling) of the wellbore 102, a logging tool 108 may be run into the wellbore 102 and communicably coupled to a computing system 120 through a wireline 106. Generally, the logging tool 108 (*e.g.,* a MWD or LWD tool) may evaluate and/or measure physical properties of the subterranean zones 116 and/or 118, including pressure, temperature, and wellbore trajectory in three-dimensional space. The measurements may be made downhole, stored in solid-state memory for some time and later transmitted to the surface 104 (*e.g.,* for storage and/or analysis). In some embodiments, the logging tool 108 may measure formation parameters (*e.g.,* resistivity, porosity, sonic velocity, gamma ray). Such formation and physical properties may be transmitted and/or transferred (*e.g.,* at the surface 104) to the computing system 120 for storage in memory 126. For example, as illustrated, such properties may be stored as geologic data properties 128 in the illustrated memory 126.

The illustrated computing system 120 includes a computer 122 that includes a graphic user interface 124, a processor 134, an interface 136, the memory 126, and the wellbore stress engine 132. Although illustrated as a single computer, the computer 122 may be, for example, a distributed client-server environment, multiple computers, or a stand-alone computing device, as appropriate. For example, in some embodiment, the computer 122 may comprise a server that stores one or more applications (*e.g.,* the wellbore stress engine 132) and application data. In some instances, the computer 122 may comprise a web server, where the applications represent one or more web-based applications accessed and executed via a network by one or more clients (not shown).

At a high level, the computer 122 comprises an electronic computing device operable to receive, transmit, process, store, or manage data and information associated with the computing system 120. Specifically, the computer 122 may receive application requests from one or more client applications associated with clients of the system 120 and respond to the received requests by processing said requests in the wellbore stress engine 132, and sending the appropriate response from the wellbore stress engine 132 back to the requesting client application. Alternatively, the computer 122 may be a client device (*e.g.,* personal computer, laptop computer, PDA, tablet, smartphone, cell phone, other mobile device, or other client computing device) that is communicably coupled to a server or server pool (not shown).

As used in the present disclosure, the term "computer" is intended to encompass any suitable processing device. For example, although FIG. 1 illustrates a single computer 122, the system 120 can be implemented using two or more servers 102, as well as computers other than servers, including a server pool. Indeed, computer 122 may be any computer or processing device such as, for example, a blade server, general-purpose personal computer (PC), Macintosh, workstation, UNIX-based workstation, or any other suitable device. In other words, the present disclosure contemplates computers other than general purpose computers, as well as computers without conventional operating systems. Further, illustrated computer 122 may be adapted to execute any operating system, including Linux, UNIX, Windows, Mac OS, or any other suitable operating system.

As illustrated in FIG. 1, computer 122 includes a processor 134. Although illustrated as a single processor 134 in FIG. 1, two or more processors may be used according to particular needs, desires, or particular embodiments of the computer 122. Each processor 134 may be a central processing unit (CPU), a blade, an application specific integrated circuit (ASIC), a field-programmable gate array (FPGA), or another suitable component. Generally, the processor 134 executes instructions and manipulates data to perform the operations of computer 122 and, specifically, the wellbore stress engine 132. Specifically, the processor 134 executes the functionality required to receive and respond to requests, as well as the functionality required to perform the operations of the software of wellbore stress engine 132.

Regardless of the particular implementation, "software" may include computer-readable instructions, firmware, wired or programmed hardware, or any combination thereof on a tangible medium operable when executed to perform at least the processes and operations described herein. Indeed, each software component may be fully or partially written or described in any appropriate computer language including C, C++, Java, Visual Basic, assembler, Perl, any suitable version of 4GL, as well as others. It will be understood that while portions of the software illustrated in FIG. 1 are shown as individual modules that implement the various features and functionality through various objects, methods, or other processes, the software may instead include a number of sub-modules, third party services, components, libraries, and such, as appropriate. Conversely, the features and functionality of various components can be combined into single components as appropriate.

At a high level, the wellbore stress engine 132 is any application, program, module, process, or other software that may execute, change, delete, generate, or otherwise manage information according to the present disclosure, particularly in response to and in connection with one or more requests received from, for example, a user of the computer 122 or other client devices. In certain cases, the system 120 may implement a composite wellbore stress engine 132. For example, portions of the wellbore stress engine 132 may be implemented as Enterprise Java Beans (EJBs) or design-time components that have the ability to generate run-time implementations into different platforms, such as J2EE (Java 2 Platform, Enterprise Edition) or Microsoft's .NET, among others.

Additionally, the wellbore stress engine 132 may represent a web-based application accessed and executed by remote clients or client applications via a network (*e.g.,* through the Internet). Further, while illustrated as internal to computer 122, one or more processes associated with the wellbore stress engine 132 may be stored, referenced, or executed remotely. For example, a portion of the wellbore stress engine 132 may be a web service associated with the application that is remotely called, while another portion of the wellbore stress engine 132 may be an interface object or agent bundled for processing at a remote client. Moreover, any or all of the wellbore stress engine 132 may be a child or sub-module of another software module or enterprise application (not illustrated) without departing from the scope of this disclosure.

The illustrated computer 122 also includes memory 126. Memory 126 may include any memory or database module and may take the form of volatile or non-volatile memory including, without limitation, magnetic media, optical media, random access memory (RAM), read-only memory (ROM), removable media, or any other suitable local or remote memory component. Memory 126 may store various objects or data, including classes, frameworks, applications, backup data, business objects, jobs, web pages, web page templates, database tables, repositories storing business and/or dynamic information, and any other appropriate information including any parameters, variables, algorithms, instructions, rules, constraints, or references thereto associated with the purposes of the computer 122 and the wellbore stress engine 132. For example, the memory 126 may store geologic data 128 gathered and/or measured by the logging tool 108. Further, the memory 126 may store one or more geomechanical models 130 generated, derived, and/or developed based on the geologic data 128. For example, a particular geomechanical model 130 may describe properties (*e.g.,* pressure, temperature, resistivity, porosity, sonic velocity, gamma ray, and other properties) of a particular formation (*e.g.,* shale, sandstone, coal, gneiss, limestone, marble, granite, basalt, schist, and other rock) that comprises all or part of a subterranean zone.

The GUI 124 comprises a graphical user interface operable to interface with at least a portion of the system 120 for any suitable purpose, including generating a visual representation of the wellbore stress engine 132 (in some instances, the web browser) and the interactions with the wellbore stress engine 132, including the responses received from the wellbore stress engine 132 received in response to the requests sent by a user and, for example, graphical or numerical representations of the geologic data 128 and/or the geomechanical models 130. Generally, through the GUI 124, the user is provided with an efficient and user-friendly presentation of data provided by or communicated within the system. The term "graphical user interface," or GUI, may be used in the singular or the plural to describe one or more graphical user interfaces and each of the displays of a particular graphical user interface. Therefore, the GUI 124 can represent any graphical user interface, including but not limited to, a web browser, touch screen, or command line interface (CLI) that processes information in the system 120 and efficiently presents the information results to the user.

The computer 122 may communicate, *e.g.,* to the logging tool 108 through the wireline 106, to one or more other systems or computers on a network, or to one or more other computers or systems via the Internet, through an interface 136. The interface 136 is used by the computer 122 for communicating with other systems in a client-server or other distributed environment (including within system 120) connected to a network. Generally, the interface 136 comprises logic encoded in software and/or hardware in a suitable combination and operable to communicate with a network. More specifically, the interface 136 may comprise software supporting one or more communication protocols associated with communications such that a network or interface's hardware is operable to communicate physical signals within and outside of the illustrated system 120.

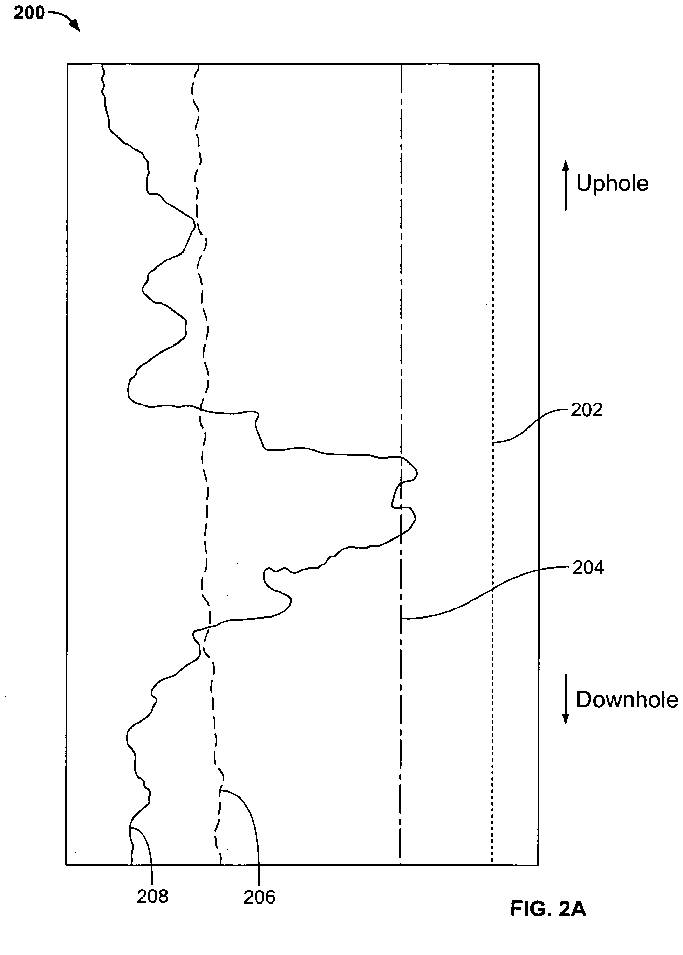

FIG. 2A is a graphical representation of an example wellbore log 200 that includes geologic data associated with one or more subterranean zones. The illustrated log 200 may graphically and/or numerically represent a continuous measurement of formation properties by electrically powered instruments (e.g., the logging tool 108) to infer properties associated with the formations. Such measurements include electrical properties (resistivity and conductivity at various frequencies), sonic properties, active and passive nuclear measurements, dimensional measurements of the wellbore, formation fluid sampling, formation pressure measurement, wireline-conveyed sidewall coring tools, and others.

According to the present disclosure, in wireline measurements, the logging tool 108 (e.g., a sonde) may be lowered into the wellbore 102 on a multiple conductor, contra-helically armored wireline. Once lowered to the bottom of the wellbore 102 (or any portion or interval of interest thereof), the measurements may be taken on the way out of the wellbore 102. Certain wireline measurements are recorded continuously even though the logging tool 108 is moving. Certain fluid sampling and pressure-measuring tools may require that the logging tool 108 be stopped.

The illustrated log 200 shows measurements for minimum horizontal stress 202, drilling fluid weight 204, pore pressure 206, and shear failure gradient 208. As illustrated, in some instances (e.g., at a particular depth or depths in the wellbore 102), the measured shear failure gradient 208 may be greater than the drilling fluid weight 204. In such instances, the drilling fluid (e.g., "mud") may begin to seep into the formation by overcoming the pore pressure 206.

In some embodiments, the shear failure gradient 208 may be obtained analytically and can be calibrated from the breakout observed from image logs, while fracture gradient can be validated from a leakoff test and verified from the field observation of drilling events (e.g., lost circulation and mud loss) and from examining image logs (e.g., drilling-induced tensile wall fractures). In some embodiments, shear failure gradient is considered as a lower bound of mud weight window, while fracture gradient is considered as an upper bound of mud weight window. In addition, the minimum horizontal stress 202 an equivalent to a closure pressure, and its magnitude can be determined using a minifrac test.

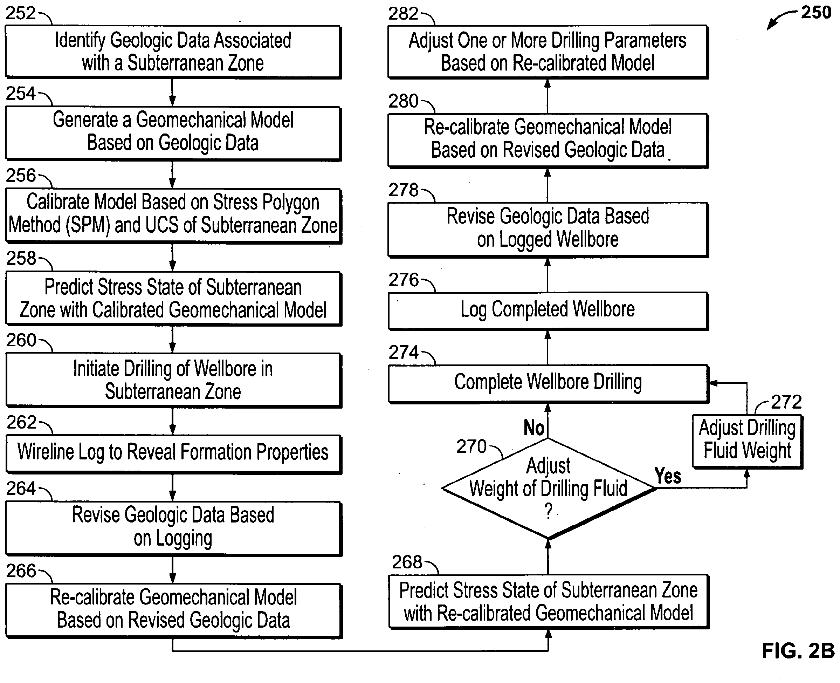

FIG. 2B illustrates an example method 250 for modeling stress around a wellbore, such as the wellbore 102. In some embodiments, all or a portion of the method 250 may be performed with the wellbore stress engine 132 illustrated in FIG. 1. Method 250 may begin at step 252, when geologic data associated with one or more subterranean zones or formations may be identified. In some embodiments, the identified geologic data may be previously stored (e.g., in memory 126) and may represent historical data associated with, for example, the particular field, formation, or wellbore. Alternatively, the geologic data can be identified based on a test, such as a LOT or minifrac. As another example, the identified geologic data can be real-time (e.g., between less than a second and several seconds) or near real-time (e.g., between several seconds and several minutes) data measured and/or determined by a logging tool.

In step 254, the wellbore stress engine (or other application) may generate a geomechanical model of the formation based on the identified geologic data. The generated geomechanical model may be represented graphically, numerically, textually, or combination thereof. For example, the geomechanical model may consist of a conceptual, three-dimensional construction of a formation, a portion of a formation, or a whole field for instance. The model may be constructed from incomplete data with some data estimated from, for example, nearby wells or from low vertical resolution data, such as seismic data. The generation of the geomechanical model can be performed by deterministic methods or geostatistical methods, or a combination of both. More generally, the geomechanical model may be a representation of a physical property or entity that can be used to make predictions or compare observations with assumptions.

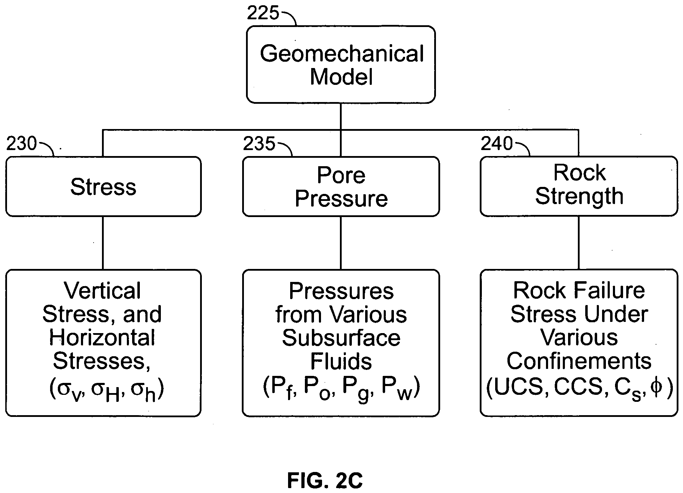

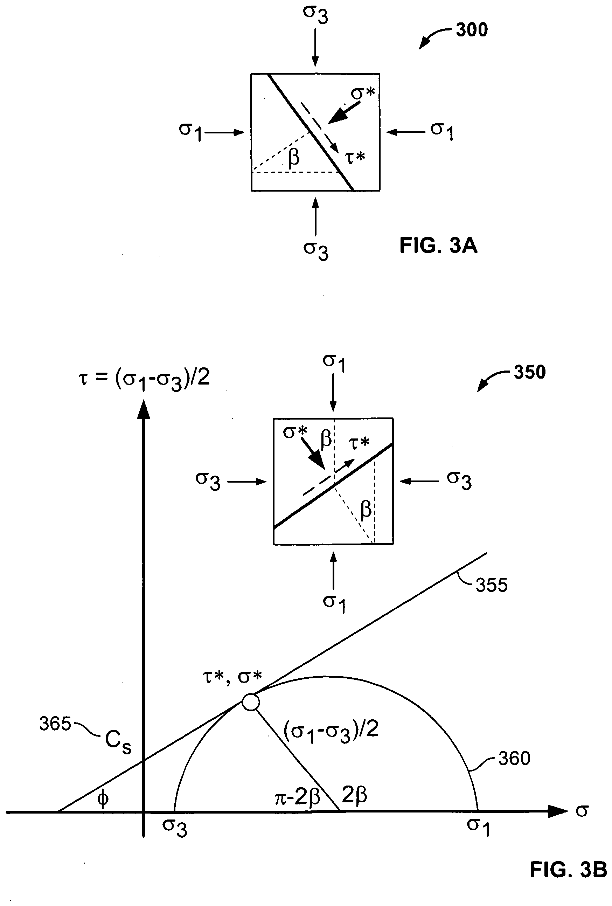

For example, turning briefly to FIG. 2C, an example geomechanical model 225 is illustrated. The illustrated geomechanical model 225 includes a stress component 230, a pore pressure component 235, and a rock strength component 240. As further illustrated in this example, the stress component 230 includes, for example, vertical stress, $\sigma_v$, and horizontal stresses, $\sigma_H$ and $\sigma_h$, (e.g., maximum and minimum horizontal stresses). The illustrated pore pressure component 235 includes, for example, pressures from various sub-surface fluids, such as single phase fluids (e.g., ground water) to multi-phase fluids (e.g., air, gas, oil, water, and other multi-phase fluids). The illustrated rock strength component 240 includes, for example, rock failure stress under various confinements (e.g., UCS and confined compressive strength, CCS), cohesion, Cs (e.g., cohesion 365 in FIG. 3B), and internal friction angle, $\phi$. In some embodiments, much like a geological model may be a tool to assist in the geological investigation, a geomechanical model is a tool to perform geomechanical study.

In step 256, the geomechanical model may be calibrated based on the stress polygon method (SPM) and an unconfined compressive strength (UCS) of the formation. For example, in some embodiments, calibrating the geomechanical model with the SPM and UCS may further include accounting for a friction coefficient of the formation. Such calibration that accounts for, e.g., the UCS and friction coefficient of the subterranean zone (e.g., the formation) may shift the stress polygon up and to the left, as illustrated and discussed below.

In step 258, a stress state of the subterranean zone is predicted based on the calibrated geomechanical model. In some embodiments, the predicted stress state may include a maximum horizontal stress of the subterranean zone.

In step 260, drilling of a wellbore into the subterranean zone may be initiated for example, accounting for the calibrated geomechanical model and predicted stress state of the subterranean zone. For example, by accounting for the predicted stress state of an overall stress regime, well stability of the wellbore may increase. For example, drilling from a surface to a targeted depth is a complex process that requires a thorough knowledge of the environments and properties of the reservoir formation, which include, but are not limited to, the in-situ stress regimes, pore pressure, formation rock strength, and others. By collecting the in-situ stresses, pore pressure, and rock strength (*e.g.,* UCS) in a calibrated geomechanical model, well stability may be more easily achieved.

In some embodiments, the stresses in the near field and far field of a vertical well are studied. For the determination of vertical stress, the integration of a density log along wellbore depth may be calculated. The verification of the measured density log can be done by comparing with the transformed density log from the sonic log using correlations. As described above, the minimum horizontal stress may be determined in a straightforward analysis according to, for example, LOT and minifrac tests. With regard to the determination of maximum horizontal stress, however, conventional methods may yield significantly different results. For an anisotropic horizontal stress field in an elastic medium, the classic solutions of near-field stresses around a wellbore subjected to the far-field stresses were given by Kirsch (1898). For an inclined well, such solutions were published by Aadnoy and Chenevert (1987). Relating to the stress-induced wellbore failure (*e.g.,* breakout and tensile wall fracture) that can be evidenced from reviewing the image logs and/or oriented caliper measurements, Zoback (2007) offered the simplified theoretical solutions of stresses around wellbore. Using the dipole sonic measurements in the stress concentrated near wellbore areas, Winkler et al. (1998) gave the formulation to link between component wellbore stresses and measured wave velocities. Sayers et al. (2009) offered a similar approach to derive the maximum wellbore stress from the interpreted sonic velocity measurements around the borehole. Based on the modified Hooke's law for 3D transverse isotropic elastic media, Higgins et al. (2008) gave the expressions of maximum horizontal stress from the known component horizontal strains.

Since the horizontal stress anisotropy is often attributed to the impact of regional tectonics, Zoback et al. (1987) developed the stress polygon method with the purpose of deriving the maximum horizontal stress graphically under the assumption that both vertical stress and minimum horizontal stress can be first known. Using commonly accepted friction faulting theory from Anderson (1951), friction defines both the limiting stress magnitudes and orientation of faults that are likely to slip. Based on conventional Coulomb frictional theory, an effective stress ratio exists when the cohesion is ignored as a simplifying assumption (Zoback, 2007).

Continuing method 250, in step 262, the wellbore may be wireline logged to reveal formation properties, *e.g.,* while drilling with the logging tool (LWD). Revised geologic data may then be determined and/or collected based on the logging in step 264. For instance, in some embodiments, the logging-while-drilling may indicate that one or more geologic data parameters identified in step 252 (*e.g.,* from historical data) may not be entirely accurate. For example, pressure, porosity, resistivity, or any other geologic data of the particular subterranean zone may be different "as logged" compared to the historical data, due to, for instance, varying values of such data within a given zone, field, formation, or other area.

In step 266, the geomechanical model may be re-calibrated to account for the revised geologic data (*e.g.,* based on the SPM and the UCS of the formation). Re-calibrating the geomechanical model with the revised geologic data using the SPM and UCS may further include accounting for the friction coefficient of the formation as in step 256.

In step 268, the stress state of the subterranean zone is predicted based on the re-calibrated geomechanical model. In some embodiments, the predicted stress state may include the maximum horizontal stress of the subterranean zone. Based on the adjusted prediction of the stress state of the subterranean zone, a determination is made in step 270 whether an adjustment of the drilling fluid is warranted. For instance, in some embodiments, the predicted stress state (*e.g.,* maximum horizontal stress) may be a lower pressure (in psi) than the weight of the drilling fluid used in drilling the wellbore. This may cause an overbalance drilling situation (*e.g.,* wellbore pressure exceeds the pressure of fluids in the formation), which may be undesirable because excessive overbalance can retard the drilling process by effectively strengthening the near-wellbore rock and limiting removal of drilled cuttings under the drilling bit. Conversely, in some situations, comparison of the drilling fluid weight and predicted stress state may reveal an underbalance drilling situation (*e.g.*, wellbore pressure is less than the pressure of fluids in the formation), which also, in some cases, may be undesirable because formation fluids may uncontrollably release into the wellbore prior to production.

If the determination is made that the weight of the drilling fluid needs to be adjusted in step 270, then an adjustment (*e.g.,* made lighter or heavier) is made to the weight of the fluid in step 272 and then the wellbore is completed in 274. If the determination is made that the weight of the drilling fluid does not need to be adjusted in step 270, then the wellbore is completed in step 274. Of course, steps 262 through 270 may be performed many times during the course of drilling the wellbore according to the present disclosure, as appropriate.

In step 276, a logging run may be made of the completed wellbore, such as by the logging tool 108. Based on the logging run of the completed wellbore, the geologic data may be revised in step 278. For instance, the final logging of the completed wellbore may indicate that one or more geologic data parameters identified in step 252 (*e.g.,* from historical data) and/or one or more geologic data parameters identified in step 262 (*e.g.,* from LWD) may not be entirely accurate. For example, pressure, porosity, resistivity, or any other geologic data of the particular subterranean zone may be different "as logged" compared to the historical data or LWD, due to, for instance, varying values of such data within a given zone, field, formation, or other area.

In step 280, the geomechanical model may be re-calibrated (*e.g.,* again) to account for the revised geologic data (*e.g.,* based on the SPM and the UCS of the formation) determined in step 278. In step 280, one or more drilling parameters (*e.g.,* for future or planned wells) may be adjusted based on re-calibrated model of step 278.

As noted above, the determination of maximum horizontal stress using conventional methods may yield significantly different results, none of which may best describe the true near-field stress state of the wellbore, *e.g.,* by accounting for rock cohesion, friction, and other real-world parameters. For instance, based on Coulomb frictional theory, the following effective stress ratio exists when the cohesion is ignored as a simplifying assumption (Zoback, 2007):

$$\frac{\sigma_1^{'}}{\sigma_3^{'}} = \frac{\sigma_1 - p}{\sigma_3 - p} = [\sqrt{(1 + \mu^2)} + \mu]^2 \qquad \text{(a)},$$

where $\sigma 1$ and $\sigma 3$ are maximum and minimum principal stresses, p is pore pressure, and $\mu$ is:

$$\mu = \tan\phi \qquad \text{(b)},$$

where $\Phi$ is the internal friction angle.

Equation (a) may be useful for defining the stress regimes (*e.g.,* the normal, strike-slip, and reverse faulting stress regimes) based on the faulting local mechanisms and relative stress magnitudes. Here, effective stress may be used instead of total stress in the stress polygon method in order to evaluate the rock failure under the specific stress conditions (*e.g.,* breakout and tensile fracture) with the bench marked by the rock strength (*e.g.,* unconfined compressive strength, or UCS).

In some embodiments of the present disclosure, a near-field stress state of the wellbore, including the maximum horizontal stress, may be predicted by a geomechanical model generated based on collected geologic data of the subterranean zone and calibrated through the stress polygon method that takes into account the UCS of the subterranean zone. Such a calibrated geomechanical model may, in some embodiments, more accurately predict the stress regime that includes the maximum horizontal stress of the wellbore, as explained more fully below.

FIGS. 3A-3C are graphical representations 300, 350, and 375, respectively, of stress and friction applied to a portion of an example subterranean zone. Turning to FIG. 3A, the graphical representation 300 illustrates a two dimensional case (*e.g.,* plane strain condition) of a rock sample that may fail from a shear plane under two differential stresses as shown. The normal and shear stresses at failure in FIG. 3A can be represented by the principal stresses as:

$$\sigma^* = 0.5(\sigma_1 + \sigma_3) + 0.5(\sigma_1 - \sigma_3)\cos 2\beta \qquad \text{(1)},$$

and

$$\tau^* = -0.5(\sigma_1 - \sigma_3)\sin 2\beta \qquad \text{(2)},$$

where $\sigma_1$ and $\sigma_3$ are the principal stresses, $\sigma^*$ and $\tau^*$ are the normal and shear stresses to the shear plane (*e.g.,* stresses at failure), and $\beta$ is the angle between the normal stress and maximum principal stress.

Turning to FIG. 3B, the graphic representation 350 illustrates a Mohr circle 360 and Coulomb line 355. Expressions in Equations (1) and (2) are best illustrated in the representation 350, where $C_s$ is the cohesion and $\phi$ is the internal friction angle. Shear stress $\tau = 0.5$ $(\sigma_1 + \sigma_3)$ is at the Mohr circle 360 center location in the lateral axis, and normal stress $\sigma = 0.5$ $(\sigma_1 - \sigma_3)$ is the radius of Mohr circle 360.

The relationship between normal and shear stresses ($\sigma$ and $\tau$) in representation 350 with respect to the Coulomb failure line 355 can be written as:

$$\tau = C_s + \mu\sigma \qquad \text{(3)},$$

where $\mu$ is the friction coefficient (*e.g.*, for a particular formation) and can be expressed as a function of internal friction angle $\phi$:

$$\mu = \tan \phi \qquad (4).$$

When the cohesion vanishes, the relationship between normal and shear stresses is linear:

$$\tau = \mu \sigma \qquad (5).$$

$\beta$ and internal friction angle $\phi$ in the graphic representation 350 can be related by the following equation:

$$\beta = \frac{\pi}{4} + \frac{\phi}{2} \qquad (6).$$

For examining the stress relationship at the shear failure, substituting $\sigma^*$ and $\tau^*$ in Equations (1) and (2) into Equation (3) leads to:

$$0.5(\sigma_1 - \sigma_3)\sin 2\beta = C_s + \mu[0.5(\sigma_1 + \sigma_3) + 0.5(\sigma_1 - \sigma_3)\cos 2\beta] \qquad (7).$$

Using the expressions of $\phi$ in Equations (4) and (6) to replace $\mu$ and $\beta$ in Equation (7) yields:

$$\sigma_1 = 2C_s \frac{\cos\phi}{1 - \sin\phi} + \sigma_3 \frac{1 + \sin\phi}{1 - \sin\phi} \qquad (8).$$

If the confining stress $\sigma_3$ in Equation (8) as shown in FIG. 3A vanishes, $\sigma_1$ in Equation (8) represents the unconfined compressive strength (UCS):

$$\sigma_1 = UCS = 2C_s \frac{\cos\phi}{1 - \sin\phi} \qquad (9).$$

Substituting Equation (6) into Equation (9), UCS can be represented by the following relationship:

$$UCS = 2C_s \frac{\cos\phi}{1 - \sin\phi} = 2C_s \tan \beta \qquad (10).$$

Substituting Equation (6) into Equation (8), the following relationship is obtained:

$$\sigma_1 = 2C_s \tan \beta + \sigma_3 \tan^2 \beta = UCS + \sigma_3 \tan^2 \beta \qquad (11).$$

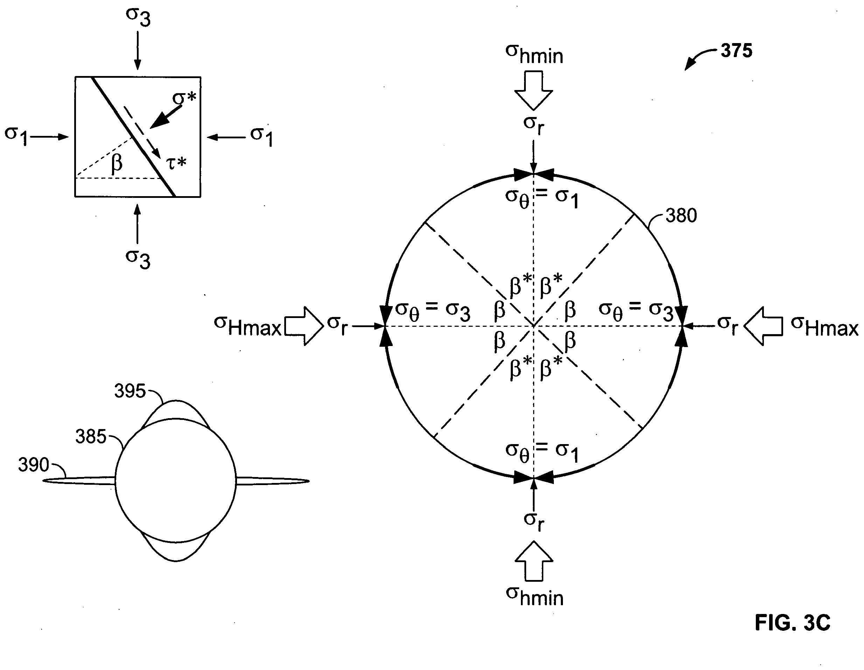

Turning to FIG. 3C, the graphic representation 375 illustrates the stressed wellbore 380 or 385 in the polar coordinate system. The normal stresses are radial stress $\sigma_r$ and hoop stress $\sigma_\theta$. For a vertical well, the maximum and minimum principal stresses are assumed to be maximum and minimum horizontal stresses. The relationships between radial-hoop stresses and maximum-minimum horizontal stresses can be depicted in FIG. 3C, where the half breakout angle $\beta^*$ and its relationship to the angle $\beta$ is also shown. Radial stress is equal to zero when there is no drilling fluid weight being applied; otherwise the radial stress is equal to the drilling fluid weight (*e.g.*, $P_m$).

The illustrated parameters $\sigma_{Hmax}$ and $\sigma_{hmin}$ are far field maximum and minimum horizontal stresses. The illustrated parameters $\sigma_1$ and $\sigma_3$ are maximum and minimum principal stresses. If the rock fails at the wellbore boundary (*e.g.*, breakout 395 or tensile fracture 390 occurs), the hoop stress, $\sigma_\theta$, is equal to the minimum principal stress, $\sigma_3$, along the far field maximum horizontal stress, $\sigma_{Hmax}$, direction, while it is equal to maximum principal stress, $\sigma_1$, along

far field minimum horizontal stress, $\sigma_{hmin}$, direction. In FIG. 3C, it is assumed that the maximum and minimum horizontals stress directions are parallel to the maximum and minimum principal stresses directions. If the maximum and minimum horizontal stresses are not parallel to the maximum and minimum principal stresses, a stress transformation may be performed. However, since the vertical stress is assumed to be one of the principal stresses, the maximum and minimum horizontal stresses may always be equal to the maximum and minimum principal stresses, respectively.

As shown in FIG. 3C, the half breakout angle $\beta^*$ (also called half breakout width) is related to the loading angle $\beta$ as:

$$\beta = \frac{\pi}{2} - \beta* \qquad (12).$$

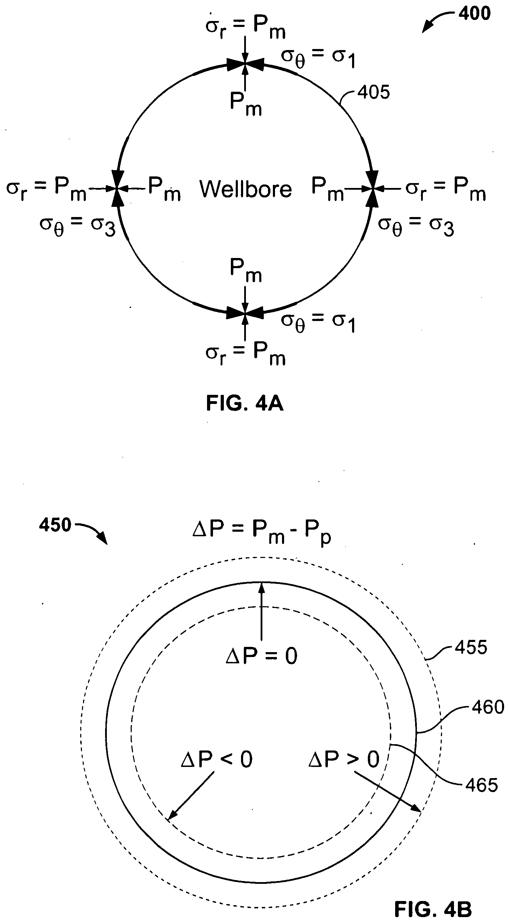

FIGS. 4A-4B are graphical representations 400 and 450, respectively, of pressure applied to a wellbore in an example subterranean zone. Turning to FIG. 4A particularly, the wellbore 405 is shown under stress as described above. Considering the effect of pore pressure and drilling fluid weight support within the well as shown, the stress equilibrium in the wellbore boundary can be expressed as:

$$\sigma_\theta - P_p = \sigma_{h\min} - P_p + \sigma_{H\max} - P_p - 2(\sigma_{H\max} - \sigma_{h\min})\cos 2\beta - P_m \qquad (13),$$

where $P_p$ is the pore pressure and $P_m$ is the drilling fluid, or mud, weight.

If the influence of pore pressure $P_p$ is also considered in FIG. 4A, the following equation exists:

$$\Delta P = P_m - P_p \qquad (14).$$

The stress is in the equilibrium state if $\Delta P = 0$, as shown in FIG. 4A. If $\Delta P$ is not equal to 0, the original wellbore radius will be reduced if $\Delta P < 0$, and will be increased if $\Delta P > 0$, as illustrated in FIG. 4B, which illustrates wellbore radii 465 (e.g., reduced), 460 (equilibrium), and 455 (increased). Equation (13) can then be rewritten as:

$$\sigma_\theta = \sigma_{h\min} + \sigma_{H\max} - 2(\sigma_{H\max} - \sigma_{h\min})\cos 2\beta - P_p - P_m \qquad (15).$$

From FIG. 4A, it is known that $\sigma_\theta = \sigma_1$ and $\sigma_3 = \Delta P$ at the rock failure (e.g., breakout). Using the relationship in Equations (11) and (14) yields:

$$\sigma_\theta = UCS + \tan^2 \beta (P_m - P_p) \qquad (16).$$

Equating (15) to (16) and assuming $\sigma_{Hmax} = \sigma_1$, $\sigma_{hmin} = \sigma_3$, and rearranging, the calculated required drilling fluid weight can be expressed as:

$$P_m = P_p + \frac{\sigma_1 + \sigma_3 - 2(\sigma_1 - \sigma_3)\cos 2\beta - 2P_p - UCS}{1 + \tan^2 \beta} \qquad (17).$$

In Equation (17), the loading angle $\beta$ is used. This $\beta$ can be substituted by the relationship with respect to the internal friction angle $\phi$ in Equation (6). As a result,

$$P_m = P_p + \frac{\sigma_1 + \sigma_3 - 2(\sigma_1 - \sigma_3)\cos(0.5\pi + \phi) - 2P_p - UCS}{1 + \tan^2(0.25\pi + 0.5\phi)} \qquad (18).$$

Alternatively, the relationship with respect to the half breakout angle $\beta^*$ in Equation (12) can be used to substitute $\beta$. Consequently, the drilling fluid weight can be rewritten as follows:

$$P_m = P_p + \frac{\sigma_1 + \sigma_3 - 2(\sigma_1 - \sigma_3)\cos(\pi - 2\beta^{\bullet}) - 2P_p - UCS}{1 + \tan^2(0.5\pi - \beta^{\bullet})} \qquad (19).$$

From the relationship between the friction coefficient $\mu$ and internal friction angle $\phi$ in Equation (4):

$$\sqrt{1 + \mu^2} + \mu = \frac{\cos\phi}{1 - \sin\phi} \qquad (20).$$

From Equation (10), it is known:

$$\tan\beta = \frac{\cos\phi}{1 - \sin\phi} \qquad (21).$$

Equating (20) and (21), yields:

$$\sqrt{1 + \mu^2} + \mu = \tan\beta \qquad (22).$$

Based on Equations (6) and (22), gives:

$$(\sqrt{1 + \mu^2} + \mu)^2 = \tan^2(\frac{\pi}{4} + \frac{\phi}{2}) \qquad (23).$$

For various rocks, the internal friction angle $\phi$, its range, and friction coefficient $\mu$ can be summarized in Table 1, from Jumikis (1983):

**Table 1**

| Rock Type | Average internal friction angle $\phi$ (degree) | Range of internal friction angle $\phi$ (degree) | Average friction coefficient $\mu$ |
|---|---|---|---|
| Shale | 27 | 15~30 | 0.51 |
| Sandstone | 31 | 27~34 | 0.6 |
| Marble | 35 | 32~37 | 0.7 |
| Limestone | 45 | 35~50 | 1 |

The unconfined compressive strength (UCS) in Equation (10) is proportional to the rock cohesion $C_s$. If the rock cohesion is zero, the relationship between the maximum principal stress $\sigma_1$ and minimum principal stress $\sigma_3$ in Equation (11) is simplified as:

$$\sigma_1 = \sigma_3 \tan^2\beta \qquad (24).$$

This equation can be used for studying the sliding friction as a result of fault movement (Anderson, 1951). From Equations (20) and (24), the relationship between the maximum principal stress $\sigma_1$ and minimum principal stress $\sigma_3$ can be represented by:

$$\frac{\sigma_1}{\sigma_3} = \tan^2\beta = (\sqrt{1 + \mu^2} + \mu)^2 \qquad (25).$$

Considering the impact of pore pressure and effective stress, Equation (25) can be re-written as:

$$\frac{\sigma_{max} - P_p}{\sigma_{min} - P_p} = (\sqrt{1 + \mu^2} + \mu)^2 \qquad (26).$$

For the normal faulting, this yields:

$$\frac{\sigma_v - P_p}{\sigma_{h\,min} - P_p} = (\sqrt{1 + \mu^2} + \mu)^2 \qquad (27),$$

where $\sigma_v$ is the vertical and the maximum stress, $\sigma_{hmin}$ is the minimum stress, and $\sigma_{Hmax}$ is the intermediate stress. For the strike-slip faulting, it yields:

$$\frac{\sigma_{H\,max} - P_p}{\sigma_{h\,min} - P_p} = (\sqrt{1 + \mu^2} + \mu)^2 \qquad (28),$$

where $\sigma_{Hmax}$ is the maximum stress, $\sigma_{hmin}$ is the minimum stress, and $\sigma_v$ is the intermediate stress. For the reverse faulting, this yields:

$$\frac{\sigma_{H\,max} - P_p}{\sigma_v - P_p} = (\sqrt{1 + \mu^2} + \mu)^2 \qquad (29),$$

where $\sigma_{Hmax}$ is the maximum stress, $\sigma_{hmin}$ is the intermediate stress, $\sigma_v$ is the minimum stress. If $\mu$ is equal to 0.6 (*e.g.,* for sandstone), the stress ratio from Equation (25) becomes:

$$\frac{\sigma_1}{\sigma_3} = 3.1 \qquad (30).$$

Using the effective stress ratio and assuming that the friction coefficient $\mu$ is equal to 0.578, Equation (28) can be re-written as:

$$\frac{\sigma_{H\,max} - P_p}{\sigma_{h\,min} - P_p} = 3.0 \qquad (31).$$

If $\beta$ in FIG. 3C is equal to zero and drilling fluid weight is equal to zero, the effective hoop stress in Equation (13) becomes:

$$\sigma'_\theta = 3\sigma'_{h\,min} - \sigma'_{H\,max} \qquad (32).$$

For a vanishing effective tensile stress (*e.g.,* $\sigma'_\theta = 0$), Equation (32) becomes:

$$\frac{\sigma'_{H\,max}}{\sigma'_{h\,min}} == 3.0 \qquad (33).$$

Equation (31) is identical to Equation (33). Equation (31) may represent a critical stage where the rock tensile strength is assumed to be zero. From the relationship between $\mu$ and $\phi$ in Equation (23), either $\mu$ is equal to 0.578 or $\phi$ is equal to 30°, the relationship in Equation (31) may always hold. As shown, the relationship between the maximum and minimum stresses is different from the relationship shown in Equation (25) than that shown in Equation (11) due to dropping the rock cohesion by Equation (25).

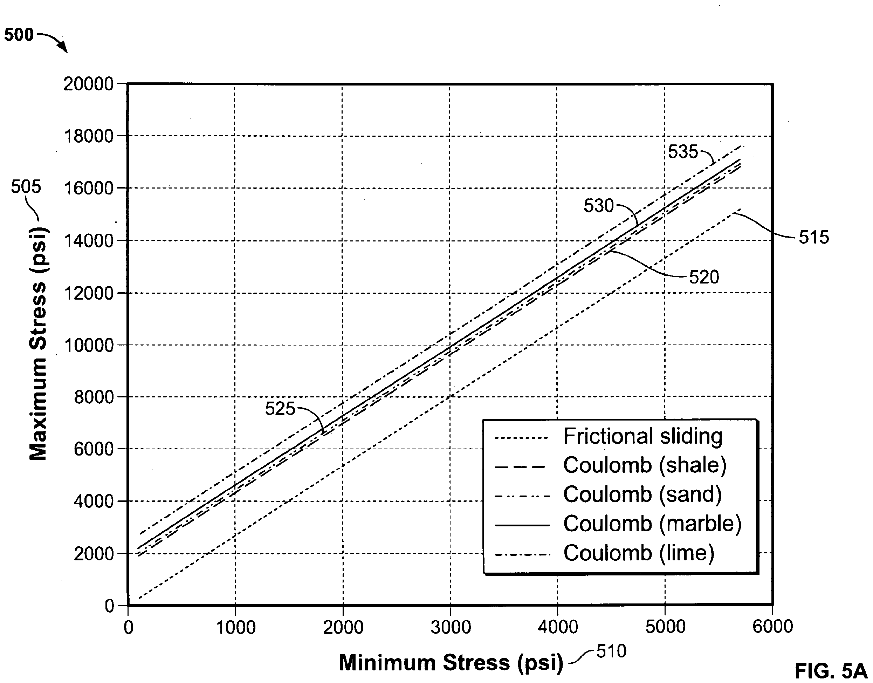

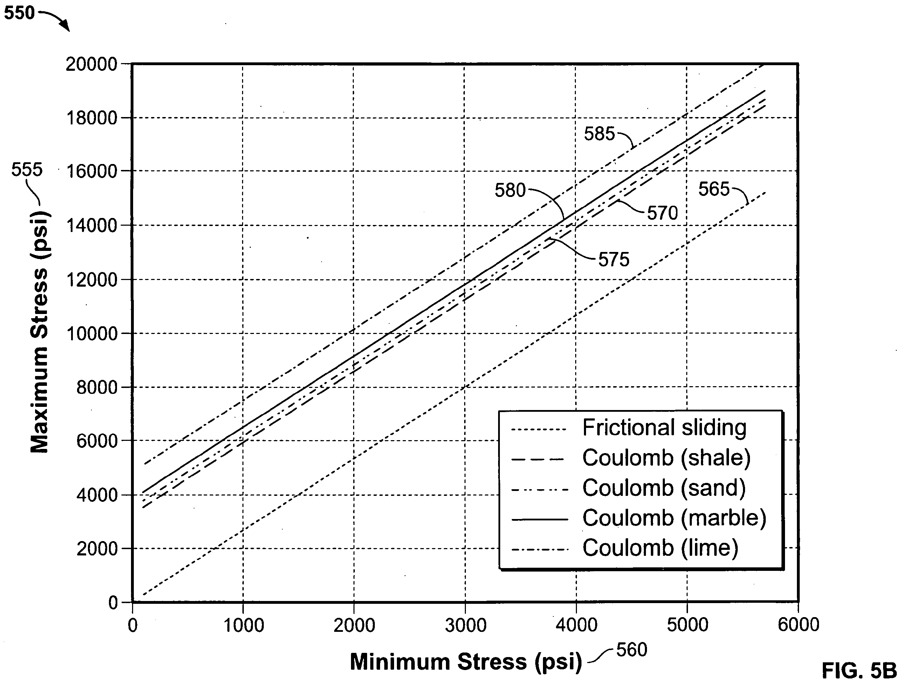

FIGS. 5A-5B are example graphs 500 and 550, respectively, of maximum stress vs. minimum stress for frictional sliding and Mohr-Coulomb solutions that have example cohesion values. Turning to FIG. 5A, maximum stress is plotted on the y-axis 505 in psi, while minimum stress is plotted on the x-axis 510 in psi. FIG. 5A shows the comparison of relations between the maximum and minimum stresses using Equation (25) and using Equation (11) with a cohesion of 500 psi for various rocks described in Table 1, above. Turning to FIG. 5B, maximum stress is plotted on the y-axis 555 in psi, while minimum stress is plotted on the x-axis 560 in psi. FIG. 5B shows the comparison of relations between the maximum and minimum stresses using Equation (25) and using Equation (11) with a cohesion of 1000 psi for various rocks described in Table 1, above.

In FIG. 5A, curve 515 represents frictional sliding, *e.g.,* a cohesion of 0 psi, while curves 520, 525, 530, and 535 represent the relationship of max vs. min stress at a cohesion of 500 psi for shale, sand, marble, and lime, respectively. In FIG. 5B, curve 565 represents frictional sliding, *e.g.,* a cohesion of 0 psi, while curves 570, 575, 580, and 585 represent the relationship of max vs. min stress at a cohesion of 1000 psi for shale, sand, marble, and lime, respectively. As illustrated in these figures, the difference in solutions between non-cohesive frictional sliding and cohesive Mohr-Coulomb criterion increases as the magnitude of cohesion increases.

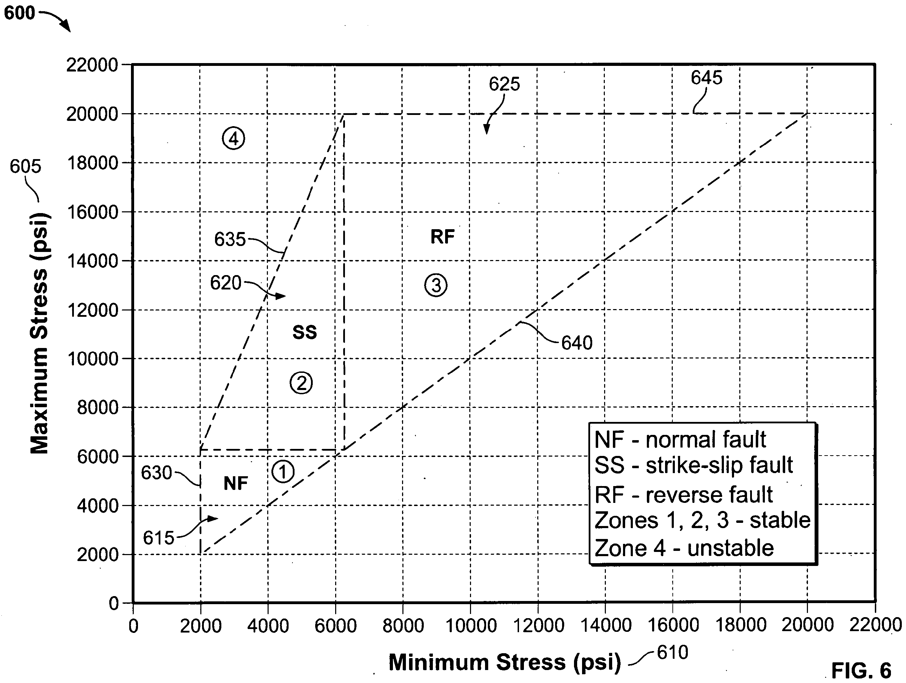

As noted above, the stress polygon method (Zoback 2007) may graphically represent the stress regimes under three faulting mechanisms: normal, strike-slip, and reverse faults. This is also shown by Equations (27), (28) and (29) using Anderson's faulting theory (1951), as shown in FIG. 6 below. Note that the sliding surfaces divide the stable zones from unstable zones for various faulting mechanisms. For this scenario, the rock cohesion is assumed to be zero. The cases in FIGS. 5A-5B and the relationship in Equation (11) indicate that Mohr-Coulomb criterion and Anderson's faulting theory are separated by the UCS. In other words, the maximum stress from Mohr-Coulomb criterion may always be greater than that from Anderson's faulting theory by a magnitude of UCS.

FIG. 6 is an example graph 600 of maximum stress vs. minimum stress for stress regimes under three faulting mechanisms - normal (NF) 615, strike-slip (SS) 620, and reverse (RF) 625 - according to the stress polygon method. As illustrated, maximum stress is plotted on the y-axis 605 in psi, while minimum stress is plotted on the x-axis 610 in psi. Further, three sliding surfaces are represented by a constant minimum stress surface 630, a constant maximum stress surface 645, and a variable sliding surface 635 that bounds edges of the three faulting mechanisms. Curve 640 represents the max stress = min stress curve. In some instances, the three zones, NF 615, SS 620, and RF 625, may be stable while points of max and min stress combinations outside of the zones may be considered unstable.

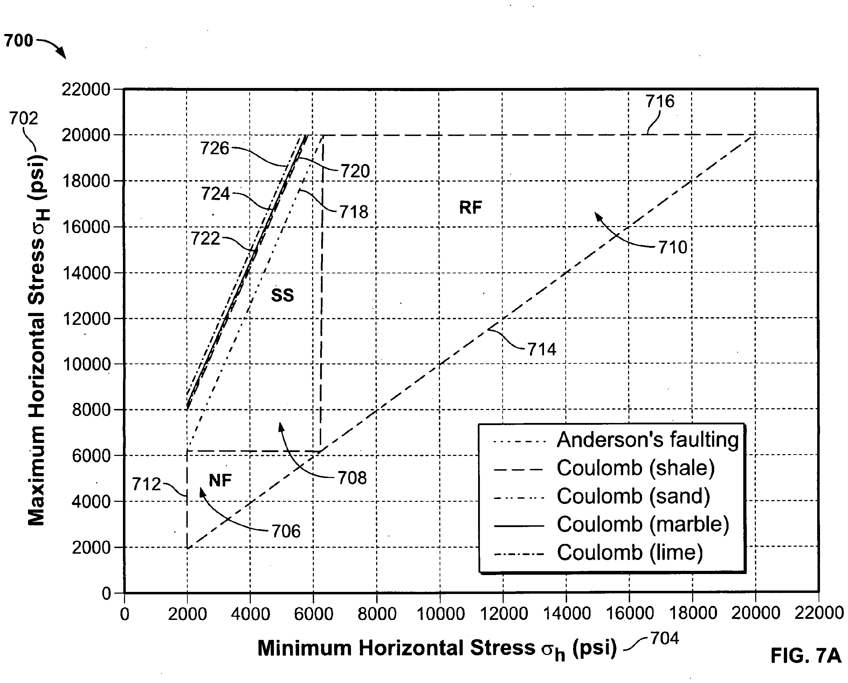

FIGS. 7A-7B are example graphs 700 and 750, respectively, comparing Anderson's and Mohr-Coulomb solutions of maximum stress vs. minimum stress for stress regimes under three faulting mechanisms - NF, SS, and RF - according to the stress polygon method at different example cohesion values and for different rock formations. FIG. 7A represents a comparison of Anderson's and Mohr-Coulomb solutions of maximum stress vs. minimum stress for stress regimes under NF, SS, and RF according to the stress polygon method at a cohesion value of 500 psi. As illustrated, NF 706, SS 708, and RF 710 represent the three faulting mechanisms, while maximum stress is plotted on the y-axis 702 in psi and minimum stress is plotted on the x-axis 704 in psi. Further, three sliding surfaces are represented by a constant minimum stress surface, $\sigma_h$, 712, a constant maximum stress surface, $\sigma_H$, 716, and Anderson's faulting 718 that bound edges of the three faulting mechanisms. Baseline curve 714 represents the max stress = min stress curve (*e.g.*, $\sigma_H = \sigma_h$).

Here, the baseline curve 714 may ensure that $\sigma_h$ will be equal or smaller than $\sigma_H$. Since the stress polygon defines the stress regime at a particular depth, the vertical stress is fixed. The constant minimum stress surface, $\sigma_h$, 712 defines the lower bound of $\sigma_h$ at that depth, while the constant maximum stress surface, $\sigma_H$, 716, defines the upper bound of SH at that depth, respectively. The relationship of Anderson's faulting 718 (*e.g.*, $\sigma_H = 3.1\ \sigma_h$) defines the outer boundary for the SS 708. The divider between NF 706 and SS 708 ensures that the vertical stress is the maximum stress for NF 706, and is the intermediate stress for SS 708. The divider between SS 708 and RF 710 ensures that the vertical stress is the minimum stress for NF 706, and is the intermediate stress for SS 708.

Curves 720, 722, 724, and 726 represent the Mohr-Coulomb solutions for shale, sand, marble, and lime, respectively. As illustrated, each of the curves 720, 722, 724, and 726 are shifted up and to the left of Anderson's faulting 718.

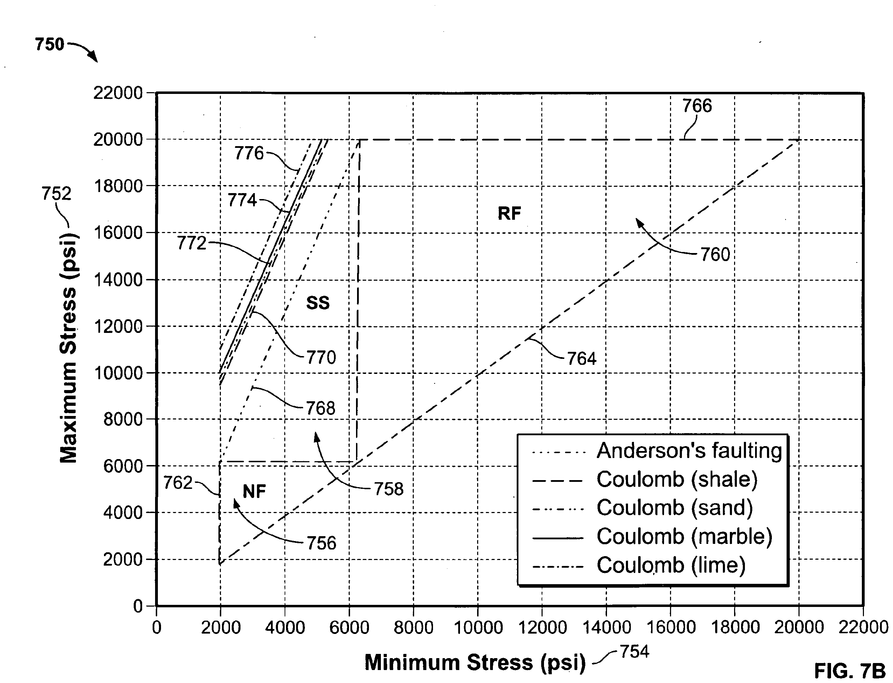

FIG. 7B represents a comparison of Anderson's and Mohr-Coulomb solutions of maximum stress vs. minimum stress for stress regimes under NF, SS, and RF according to the stress polygon method at a cohesion value of 1000 psi. As illustrated, NF 756, SS 758, and RF 760 represent the three faulting mechanisms, while maximum stress is plotted on the y-axis 752 in psi and minimum stress is plotted on the x-axis 754 in psi. Further, three sliding surfaces are represented by a constant minimum stress surface, $\sigma_h$, 762, a constant maximum stress surface, $\sigma_H$, 766, and Anderson's faulting 768 that bound edges of the three faulting mechanisms. Baseline curve 764 represents the max stress = min stress curve (*e.g.*, $\sigma_H = \sigma_h$).

As with FIG. 7A, the baseline curve 764 may ensure that $\sigma_h$ will be equal or smaller than $\sigma_H$. Since the stress polygon defines the stress regime at a particular depth, the vertical stress is fixed. The constant minimum stress surface, $\sigma_h$, 762 defines the lower bound of $\sigma_h$ at that depth, while the constant maximum stress surface, $\sigma_H$, 766, defines the upper bound of SH at that depth, respectively. The relationship of Anderson's faulting 768 (*e.g.*, $\sigma_H = 3.1\ \sigma_h$) defines the outer boundary for the SS 758. The divider between NF 756 and SS 758 ensures that the vertical stress is the maximum stress for NF 756, and is the intermediate stress for SS 758. The divider between SS 758 and RF 760 ensures that the vertical stress is the minimum stress for NF 706, and is the intermediate stress for SS 758.

Curves 770, 772, 774, and 776 represent the Mohr-Coulomb solutions for shale, sand, marble, and lime, respectively. As illustrated, each of the curves 770, 772, 774, and 776 are shifted up and to the left of Anderson's faulting 768.

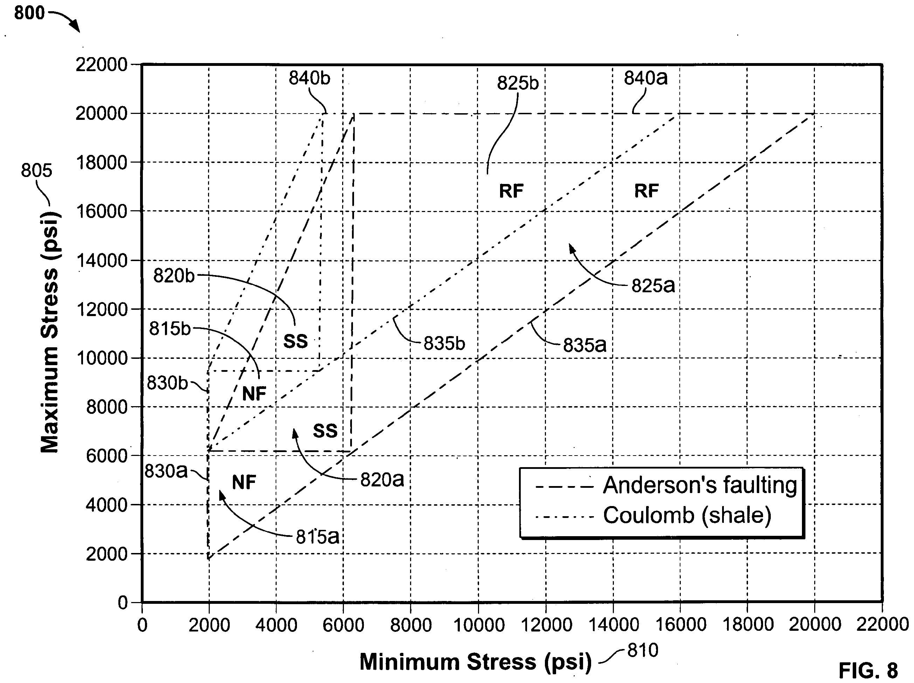

As illustrated, the stress polygons shown in FIGS. 7A-7B are from Anderson's faulting mechanisms. The stress polygon from Mohr-Coulomb criterion should exist independently from Anderson's theory. Using the cohesion of 1000 psi and selecting the shale, FIG. 8 compares two stress polygons between the one from Anderson's theory and the one from Mohr-Coulomb criterion. FIG. 8 is an example graph 800 comparing Anderson's and Mohr-Coulomb solutions of maximum stress vs. minimum stress for stress regimes under NF, SS, and RF according to the stress polygon method for an example geologic formation; here, the formation is shale.

As illustrated, maximum stress is plotted on the y-axis 805 in psi and minimum stress is plotted on the x-axis 810 in psi. Further, three sliding surfaces are represented for each solution (*e.g.,* Anderson's and Mohr-Coulomb) by a constant minimum stress surface, $\sigma_h$, 830a and 830b, and a constant maximum stress surface, $\sigma_H$, 840a and 840b. Baseline curves 835a and 835b represent the max stress = min stress curve (*e.g.,* $\sigma_H = \sigma_h$) for Anderson's faulting and Mohr-Coulomb, respectively.

As shown, the set of stress polygons with the "a" designation represent the Anderson's faulting stress polygons while the set of stress polygons with the "b" designation represent the Mohr-Coulomb solutions, both for shale. For example, NF 815a and NF 815b are the Anderson's faulting and the Mohr-Coulomb solutions, respectively; SS 820a and SS 820b are the Anderson's faulting and the Mohr-Coulomb solutions, respectively, and RF 825a and RF 825b are the Anderson's faulting and the Mohr-Coulomb solutions, respectively.

As illustrated, none of these stress polygons moves outside the triangle defined by the minimum possible horizontal stress (*e.g.,* 2,000 psi), maximum possible horizontal stress (*e.g.,* 20,000 psi), and the equal value line between minimum stress and maximum stress (*e.g.,* min stress = max stress). In comparison with the stress polygon from the Anderson's approach, the stress polygon by the Mohr-Coulomb criterion moves towards the upper-left corner of the domain (*e.g.,* greater maximum stress, and smaller minimum stress).

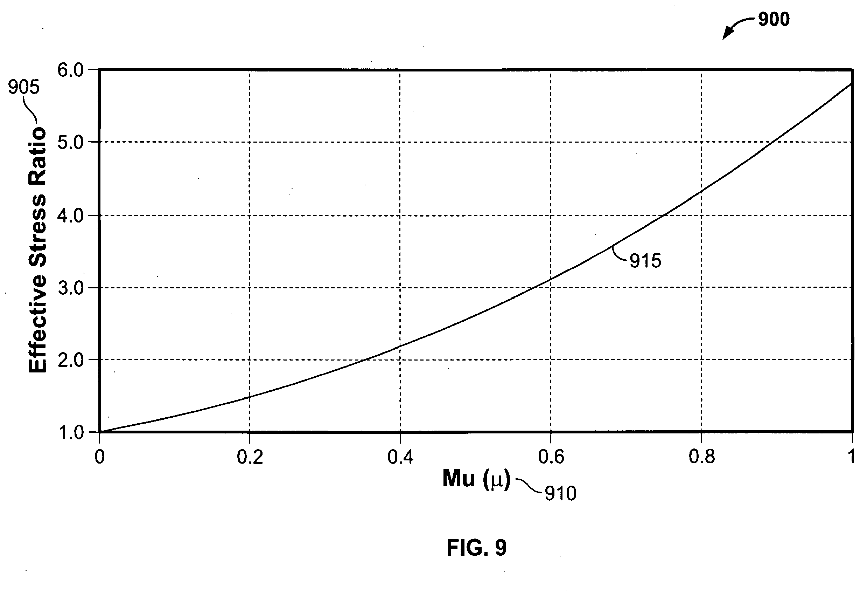

FIG. 9 is an example graph 900 of effective stress ratio vs. friction coefficient for stress regimes according to the stress polygon method for an example geologic formation. As illustrated, effective stress ratio is plotted on the y-axis 905 (dimensionless) and friction coefficient, $\mu$, is plotted on the x-axis 910 (dimensionless). As illustrated, the relationship between effective stress ratio and $\mu$, is non-linear. Since the friction coefficient $\mu$ represents the shear strength, the greater $\mu$ is, the greater the slope between maximum and minimum stresses will be. Further, based on the relationship between the effective stress ratio and the friction coefficient $\mu$, the effective stress ratios vary for different friction coefficients, as shown in Table 2, below.

**Table 2**

| Friction coefficient $\mu$ | Relation $(\sqrt{1+\mu^2}+\mu)^2$ | Effective stress ratio $\dfrac{\sigma_{max}-P_p}{\sigma_{min}-P_p}$ |
|---|---|---|
| 0 | 1.00 | 1.00 |
| 0.1 | 1.22 | 1.22 |
| 0.2 | 1.49 | 1.49 |
| 0.3 | 1.81 | 1.81 |
| 0.4 | 2.18 | 2.18 |
| 0.5 | 2.62 | 2.62 |
| 0.6 | 3.12 | 3.12 |
| 0.7 | 3.69 | 3.69 |
| 0.8 | 4.33 | 4.33 |
| 0.9 | 5.04 | 5.04 |
| 1.0 | 5.83 | 5.83 |

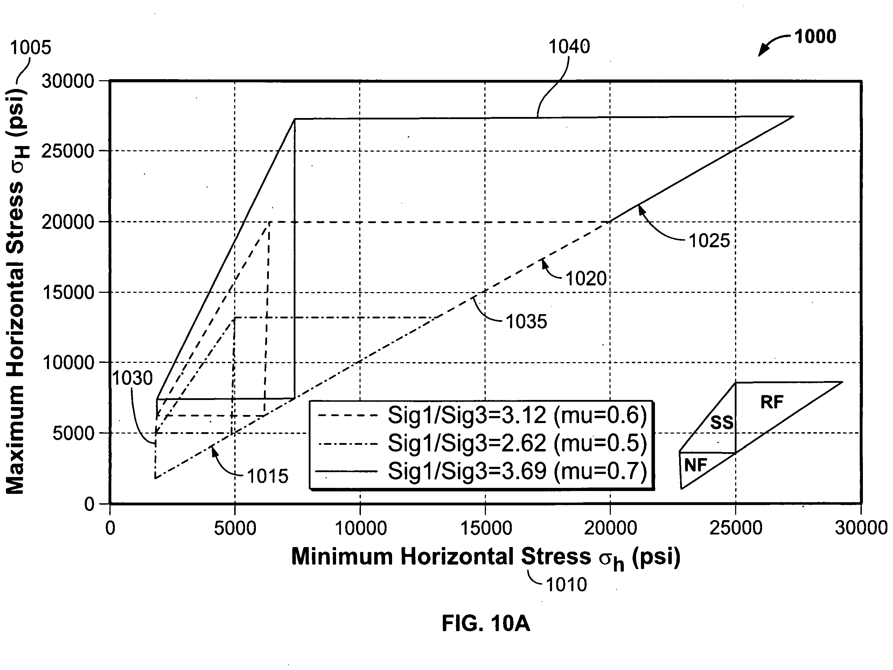

FIGS. 10A-10B are example graphs 1000 and 1050, respectively, of maximum stress vs. minimum stress for stress regimes under NF, SS, and RF according to the stress polygon method for various example frictional coefficients.

For example, turning to FIG. 10A, demonstrates the three polygons (combined zones of NF, SS, and RF) for different $\mu$ ($\mu$ =0.5, 0.6, or 0.7). As illustrated, generally, greater $\mu$ results in a larger slope between maximum and minimum stresses.

As illustrated in FIG. 10A, maximum horizontal stress, $\sigma_H$, is plotted on the y-axis 1005 in psi and minimum horizontal stress, $\sigma_h$, is plotted on the x-axis 1010 in psi. Here, in graph 1000, $\sigma_h$ is a lower bound. Further, three sliding surfaces are represented by a constant minimum stress surface, $\sigma_h$, 1030 and a constant maximum stress surface, $\sigma_H$, 1040. Baseline curve 1035 represents the max stress = min stress curve (*e.g.*, $\sigma_H$ = $\sigma_h$).

As further illustrated, the three stress polygons 1015, 1020, and 1025 differ in size and shape due to, for instance, the particular $\mu$ used to calculate the stress polygon. For example, stress polygon 1015 is determined with a $\mu$ of 0.5, stress polygon 1020 is determined with a $\mu$ of 0.6, and stress polygon 1025 is determined with a $\mu$ of 0.7. As $\mu$ grows, therefore, the stress polygon becomes larger with a steeper slope bounding the SS fault mechanism.

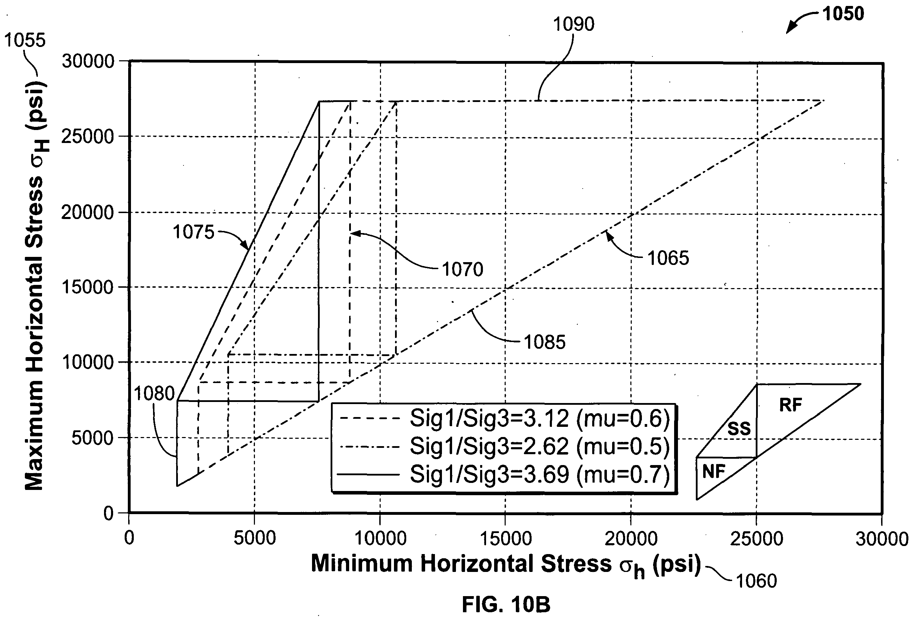

Turning to FIG. 10B, as shown in the graph 1050, maximum horizontal stress, $\sigma_H$, is plotted on the y-axis 1055 in psi and minimum horizontal stress, $\sigma_h$, is plotted on the x-axis 1060 in psi. Here, in graph 1050, the maximum stress, $\sigma_H$, is set as an upper bound. Further, three sliding surfaces are represented by a constant minimum stress surface, $\sigma_h$, 1080 and a constant maximum stress surface, $\sigma_H$, 1090. Baseline curve 1085 represents the max stress = min stress curve (*e.g.*, $\sigma_H$ = $\sigma_h$).

As further illustrated, the three stress polygons 1065, 1070, and 1075 differ in size and shape due to, for instance, the particular $\mu$ used to calculate the stress polygon. For example, stress polygon 1065 is determined with a $\mu$ of 0.5, stress polygon 1070 is determined with a $\mu$ of 0.6, and stress polygon 1075 is determined with a $\mu$ of 0.7. As $\mu$ grows, therefore, the stress polygon becomes larger with a steeper slope bounding the SS fault mechanism.

If no cap value is set to either $\sigma_h$ or $\sigma_H$, the stress polygon of various $\mu$ can float to anywhere. Under certain circumstances, the smaller stress polygon with a smaller $\mu$ can be contained within the bigger stress polygon with a greater $\mu$. With respect to the relationship between the internal friction angle $\phi$ and the friction coefficient $\mu$., Jumikis (1983) defined the relations for various rock types, as shown in Table 3, below.

**Table 3**

| Rock Type | Internal Friction Angle ($\phi$) | Friction Coefficient ($\mu$) |
|---|---|---|
| Basalt | 49 | 1.15 |
| Diabase | 53 | 1.31 |
| Gabbro | 21 | 0.4 |
| Granite | 53 | 1.35 |
| Dolomite | 22 | 0.4 |
| Limestone | 43 | 0.95 |
| Sandstone | 31 | 0.6 |
| Shale | 23 | 0.42 |
| Gneiss | 33 | 0.65 |
| Marble | 41 | 0.9 |
| Quartzite | 42 | 1.11 |
| Schist | 62 | 1.9 |

The relationships in Table 3 can be graphically represented as a curve or as an equation of polynomial of 2nd order with the square of relative coefficient of 0.9854:

$$\phi = 10.312 \times \mu^2 + 50.3 \times \mu + 3.63 \qquad (34).$$

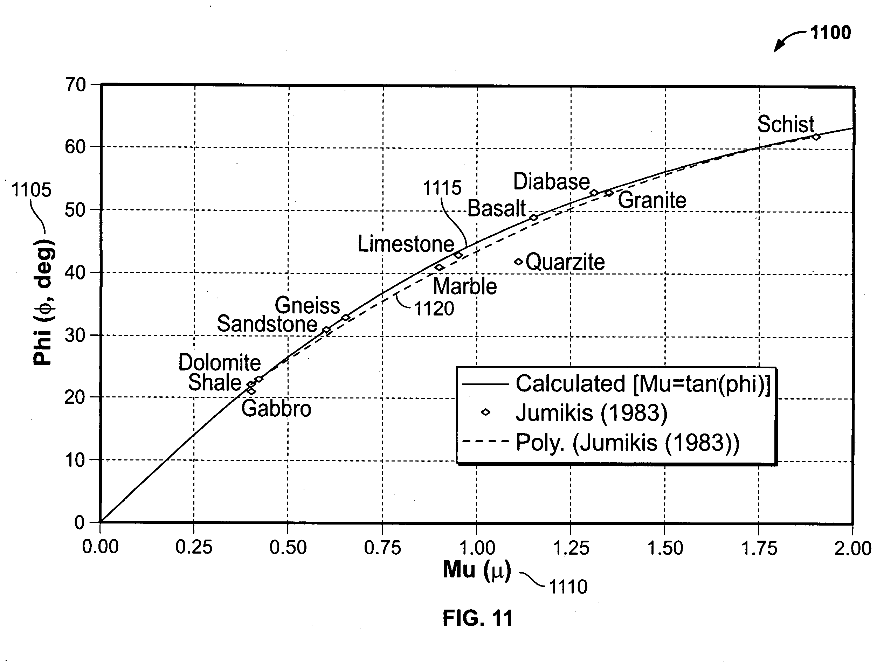

Turning briefly to FIG. 11, an example graph 1100 of internal friction angle vs. friction coefficient for various example formations according to observed and calculated values is illustrated. As shown in graph 1100, internal friction angle, $\phi$, is plotted on the y-axis 1105 in degrees and friction coefficient, $\mu$, is plotted on the x-axis 1110 (dimensionless). Curve 1115 represents the calculation:

$$\mu = \tan(\phi),$$

for the values of shown in Table 3. Curve 1120 represents a plot of Equation (34) (e.g., equation of polynomial of 2nd order with the square of relative coefficient of 0.9854). The points shown on the graph 1100 represent the particular and combinations illustrated in Table 3.

If the relationship between minimum and maximum stresses is provided, Equation (8) shows the relationship with the inclusion of cohesion. Neglecting the cohesion, the stress ratio between maximum and minimum stresses can be written from Equation (8) as:

$$\sigma_1 / \sigma_3 = \frac{1 + \sin\phi}{1 - \sin\phi} \qquad (35).$$

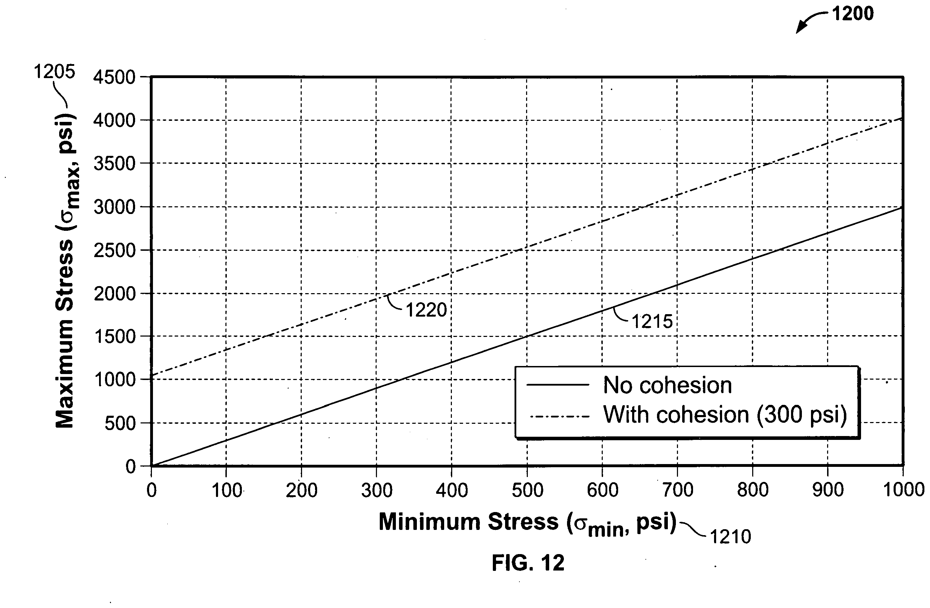

Assuming the equivalent cohesion of 300 psi, FIG. 12 compares the result from Equation (8) and that from Equation (35). FIG. 12 is an example graph 1200 of maximum stress vs. minimum stress either under no cohesion or under the cohesion of 300 psi. As shown in the graph 1200, maximum stress, $\sigma_{max}$, is plotted on the y-axis 1205 in psi and minimum stress, $\sigma_{min}$, is plotted on the x-axis 1210 in psi. Curve 1220 represents the result of Equation (8) while curve 1215 represents the result of Equation (35). As illustrated, the stress ratio in Equation (35) may represent the lower bound of stress relations.

As noted above, in some example embodiments, a wellbore stress engine may generate, calibrate, re-calibrate, and otherwise manage a geomechanical model of a subterranean zone based on collected geologic data of the subterranean zone and a stress polygon method. In some embodiments, the wellbore stress engine may calibrate and/or re-calibrate the geomechanical model based on the stress polygon model that takes into account the UCS of the subterranean zone. Such a calibrated geomechanical model may, in some embodiments, allow a well operator to determine and/or predict a stability of a wellbore being formed (or having been formed) in the subterranean zone. For instance, the well operator, driller, or well owner, for example, may determine a stress regime that includes a maximum horizontal stress of the wellbore based on the calibrated geomechanical model through execution of the wellbore stress engine.

In some embodiments, a near-field stress state of the wellbore, including the maximum horizontal stress, may be predicted by the geomechanical model generated based on collected geologic data of the subterranean zone and calibrated through the stress polygon method that takes into account the UCS of the subterranean zone. Such a calibrated geomechanical model may, in some embodiments, more accurately predict the stress regime that includes the maximum horizontal stress of the wellbore.

A number of embodiments have been described. Nevertheless, it will be understood that various modifications may be made. For example, other methods described herein besides or in addition to that illustrated in FIG. 2A may be performed. Further, the illustrated steps of method 250 may be performed in different orders, either concurrently or serially. Further, steps may be performed in addition to those illustrated in method 250, and some steps illustrated in method 250 may be omitted without deviating from the present disclosure. Accordingly, other embodiments are within the scope of the following claims.

## Claims

1. A method performed with a system comprising a computer and means for initiating formation of a wellbore and means for wireline logging, for modeling stress around a wellbore, the method comprising:

   calibrating a geomechanical model (130) that comprises geologic data (128) associated with a subterranean zone (116, 118) based on a stress polygon method and an unconfined compressive strength (UCS) associated with the subterranean zone;
   generating an output of a predicted stress state of the subterranean zone based on the calibrated geomechanical model;
   initiating formation of the wellbore (102) through or proximate to the subterranean zone accounting for the calibrated geomechanical model and the predicted stress state of the subterranean zone;
   wireline logging the wellbore during formation of the wellbore; and
   revising the geologic data based on the logging; and
   re-calibrating the geomechanical model based on the revised geologic data.

2. The method of claim 1, further comprising:

    predicting, during formation of the wellbore, a revised stress state of the subterranean zone using the updated geomechanical model based on the revised geologic data.

3. The method of Claim 1 or 2, further comprising:

    receiving an identification of the geologic data associated with the subterranean zone;
    generating, based on the identified geologic data, the geomechanical model of the subterranean zone; and, optionally,
    wherein the identified geologic data comprises at least one of historical geologic data associated with the subterranean zone, or geologic data determined by a minifrac test.

4. The method of any one of the preceding claims, further comprising:

    completing the formation of the wellbore to a specified depth;
    subsequent to completing the formation of the wellbore, logging the completed wellbore;
    revising the geologic data based on the logging of the completed wellbore; and
    re-calibrating the geomechanical model based on the revised geologic data; and/or,
    wherein the stress state of the subterranean zone comprises a maximum horizontal stress of the subterranean zone; and, optionally,
    wherein calibrating the geomechanical model based on the stress polygon method and the UCS associated with the subterranean zone comprises shifting a polygon defined by the stress polygon method based on the UCS and a friction coefficient associated with the subterranean zone.

5. The method of any one of the preceding claims, further comprising adjusting a weight of a drilling fluid based on the predicted stress state of the subterranean zone; and/or,
    wherein the geologic data comprises one or more of gamma ray data, resistivity data, or sonic data, associated with the subterranean zone.

6. A computer storage medium encoded with a computer program, the program comprising instructions that when executed by a system comprising one or more computers and means for initiating a wellbore and means for wireline logging, cause the system to perform operations including the steps of the method of claim 1.

7. The computer storage medium of claim 6, wherein the operations further comprise:
    predicting, during formation of the wellbore, a revised stress state of the subterranean zone using the updated geomechanical model based on the revised geologic data.

8. The computer storage medium of any one of the preceding claims 6 or 7, wherein the operations further comprise:

    receiving an identification of the geologic data associated with the subterranean zone;
    generating, based on the identified geologic data, the geomechanical model of the subterranean zone; and, optionally,
    wherein the identified geologic data comprises at least one of historical geologic data associated with the subterranean zone, or geologic data determined by a minifrac test.

9. The computer storage medium of any one of the preceding claims 6, 7 or 8, wherein the operations further comprise:

    completing the formation of the wellbore to a specified depth;
    subsequent to completing the formation of the wellbore, logging the completed wellbore;
    revising the geologic data based on the logging of the completed wellbore; and
    re-calibrating the geomechanical model based on the revised geologic data; and/or,
    wherein the stress state of the subterranean zone comprises a maximum horizontal stress of the subterranean zone, and, optionally,
    wherein calibrating the geomechanical model based on the stress polygon method and the UCS associated with the subterranean zone comprises shifting a polygon defined by the stress polygon method based on the UCS and a friction coefficient associated with the subterranean zone.

10. The computer storage medium of any one of the preceding claims 6 through 9, wherein the operations further comprise adjusting a weight of a drilling fluid based on the predicted stress state of the subterranean zone; and/or, wherein the geologic data comprises one or more of gamma ray data, resistivity data, or sonic data, associated with the subterranean zone.

11. A system comprising one or more computers and means for initiating formation of a wellbore and means for wireline logging, the system configured to perform operations including the steps of the method of claim 1.

12. The system of claim 11, wherein the operations further comprise:
predicting, during formation of the wellbore, a revised stress state of the subterranean zone using the updated geomechanical model based on the revised geologic data.

13. The system of any one of the preceding claims 11 or 12, wherein the operations further comprise:

receiving an identification of the geologic data associated with the subterranean zone;
generating, based on the identified geologic data, the geomechanical model of the subterranean zone; and, optionally,
wherein the identified geologic data comprises at least one of historical geologic data associated with the subterranean zone, or geologic data determined by a minifrac test.

14. The system of any one of the preceding claims 11, 12 or 13, wherein the operations further comprise:

completing the formation of the wellbore to a specified depth;
subsequent to completing the formation of the wellbore, logging the completed wellbore;
revising the geologic data based on the logging of the completed wellbore; and
re-calibrating the geomechanical model based on the revised geologic data; and/or,
wherein the stress state of the subterranean zone comprises a maximum horizontal stress of the subterranean zone; and, optionally,
wherein calibrating the geomechanical model based on the stress polygon method and the UCS associated with the subterranean zone comprises shifting a polygon defined by the stress polygon method based on the UCS and a friction coefficient associated with the subterranean zone.

15. The system of any one of the preceding claims 11 through 14, wherein the operations further comprise adjusting a weight of a drilling fluid based on the predicted stress state of the subterranean zone; and/or, wherein the geologic data comprises one or more of gamma ray data, resistivity data, or sonic data, associated with the subterranean zone.


**Patentansprüche**

1. Verfahren, durchgeführt mit einem System, das einen Computer und Mittel zum Initiieren der Formation eines Bohrlochs und Mittel zur Drahtleitungsprotokollierung umfasst, zur Modellierung der Belastung rund um ein Bohrloch, wobei das Verfahren Folgendes umfasst:

Kalibrieren eines geomechanischen Modells (130), das geologische Daten (128) in Verbindung mit einem unterirdischen Bereich (116, 118) umfasst, basierend auf einem Belastungspolygonverfahren und einer unbehinderten Druckfestigkeit (unconfined compressive strength - UCS) in Verbindung mit dem unterirdischen Bereich;
Erzeugen einer Ausgabe eines vorhergesagten Belastungszustands des unterirdischen Bereichs basierend auf dem kalibrierten geomechanischen Modell;
Initiieren der Formation des Bohrlochs (102) durch den oder nahe dem unterirdischen Bereich, der das kalibrierte geomechanische Modell und den vorhergesagten Belastungszustand des unterirdischen Bereichs ausmacht;
Drahtleitungsprotokollieren des Bohrlochs während der Formation des Bohrlochs; und
Überprüfen der geologischen Daten basierend auf dem Protokollieren; und
erneutes Kalibrieren des geomechanischen Modells basierend auf den überprüften geologischen Daten.

2. Verfahren nach Anspruch 1, ferner umfassend:
Vorhersagen, während der Formation des Bohrlochs, eines geprüften Belastungszustands des unterirdischen Bereichs unter Verwendung des aktualisierten geomechanischen Modells basierend auf den überprüften geologischen Daten.

3. Verfahren nach Anspruch 1 oder 2, ferner umfassend:

Empfangen einer Identifizierung der geologischen Daten in Verbindung mit dem unterirdischen Bereich;
Erzeugen, basierend auf den identifizierten geologischen Daten, des geomechanischen Modells des unterirdischen Bereichs; und optional
wobei die identifizierten geologischen Daten zumindest eines von historischen geologischen Daten in Verbindung mit dem unterirdischen Bereich oder durch einen Minifrac-Test bestimmten geologischen Daten umfassen.

4. Verfahren nach einem der vorhergehenden Ansprüche, ferner umfassend:

Komplettieren der Formation des Bohrlochs zu einer spezifizierten Tiefe;
Protokollieren des komplettierten Bohrlochs im Anschluss an das Komplettieren der Formation des Bohrlochs;
Überprüfen der geologischen Daten basierend auf dem Protokollieren des komplettierten Bohrlochs; und
erneutes Kalibrieren des geomechanischen Modells basierend auf den überprüften geologischen Daten; und/oder
wobei der Belastungszustand des unterirdischen Bereichs eine maximale horizontale Belastung des unterirdischen Bereichs umfasst; und optional
wobei das Kalibrieren des geomechanischen Modells basierend auf dem Belastungspolygonverfahren und der UCS in Verbindung mit dem unterirdischen Bereich das Verschieben eines Polygons definiert durch das Belastungspolygonverfahren basierend auf der UCS und einem Reibungskoeffizienten in Verbindung mit dem unterirdischen Bereich umfasst.

5. Verfahren nach einem der vorhergehenden Ansprüche, ferner umfassend das Einstellen eines Gewichts einer Bohrflüssigkeit basierend auf dem vorhergesagten Belastungszustand des unterirdischen Bereichs; und/oder
wobei die geologischen Daten eines oder mehrere von Gammastrahlendaten, Widerstandsfähigkeitsdaten oder Schalldaten in Verbindung mit dem unterirdischen Bereich umfassen.

6. Computerspeichermedium, das mit einem Computerprogramm codiert ist, wobei das Programm Anweisungen umfasst, die, wenn sie durch ein System ausgeführt werden, das einen oder mehrere Computer und Mittel zum Initiieren eines Bohrlochs und Mittel zur Drahtleitungsprotokollierung umfasst, das System dazu veranlassen, Vorgänge durchzuführen, die die Schritte des Verfahrens nach Anspruch 1 beinhalten.

7. Computerspeichermedium nach Anspruch 6, wobei die Vorgänge ferner Folgendes umfassen:
Vorhersagen, während der Formation des Bohrlochs, eines überprüften Belastungszustands des unterirdischen Bereichs unter Verwendung des aktualisierten geomechanischen Modells basierend auf den überprüften geologischen Daten.

8. Computerspeichermedium nach einem der vorhergehenden Ansprüche 6 oder 7, wobei die Vorgänge ferner Folgendes umfassen:

Empfangen einer Identifizierung der geologischen Daten in Verbindung mit dem unterirdischen Bereich;
Erzeugen, basierend auf den identifizierten geologischen Daten, des geomechanischen Modells des unterirdischen Bereichs; und optional
wobei die identifizierten geologischen Daten zumindest eines von historischen geologischen Daten in Verbindung mit dem unterirdischen Bereich oder durch einen Minifrac-Test bestimmten geologischen Daten umfassen.

9. Computerspeichermedium nach einem der vorhergehenden Ansprüche 6, 7 oder 8, wobei die Vorgänge ferner Folgendes umfassen:

Komplettieren der Formation des Bohrlochs zu einer spezifizierten Tiefe;
Protokollieren des komplettierten Bohrlochs im Anschluss an das Komplettieren der Formation des Bohrlochs;
Überprüfen der geologischen Daten basierend auf dem Protokollieren des komplettierten Bohrlochs; und
erneutes Kalibrieren des geomechanischen Modells basierend auf den überprüften geologischen Daten; und/oder
wobei der Belastungszustand des unterirdischen Bereichs eine maximale horizontale Belastung des unterirdischen Bereichs umfasst; und optional

wobei das Kalibrieren des geomechanischen Modells basierend auf dem Belastungspolygonverfahren und der UCS in Verbindung mit dem unterirdischen Bereich das Verschieben eines Polygons definiert durch das Belastungspolygonverfahren basierend auf der UCS und einem Reibungskoeffizienten in Verbindung mit dem unterirdischen Bereich umfasst.

10. Computerspeichermedium nach einem der vorhergehenden Ansprüche 6 bis 9, wobei die Vorgänge ferner das Einstellen eines Gewichts einer Bohrflüssigkeit basierend auf dem vorhergesagten Belastungszustand des unterirdischen Bereichs umfassen, und/oder

wobei die geologischen Daten eines oder mehrere von Gammastrahlendaten, Widerstandsfähigkeitsdaten oder Schalldaten in Verbindung mit dem unterirdischen Bereich umfassen.

11. System, umfassend einen oder mehrere Computer und Mittel zum Initiieren der Formation eines Bohrlochs und Mittel zur Drahtleitungsprotokollierung, wobei das System konfiguriert ist, um Vorgänge durchzuführen, die die Schritte des Verfahrens nach Anspruch 1 beinhalten.

12. System nach Anspruch 11, wobei die Vorgänge ferner Folgendes umfassen:
Vorhersagen, während der Formation des Bohrlochs, eines überprüften Belastungszustands des unterirdischen Bereichs unter Verwendung des aktualisierten geomechanischen Modells basierend auf den überprüften geologischen Daten.

13. System nach einem der vorhergehenden Ansprüche 11 oder 12, wobei die Vorgänge ferner Folgendes umfassen:

Empfangen einer Identifizierung der geologischen Daten in Verbindung mit dem unterirdischen Bereich;
Erzeugen, basierend auf den identifizierten geologischen Daten, des geomechanischen Modells des unterirdischen Bereichs; und optional
wobei die identifizierten geologischen Daten zumindest eines von historischen geologischen Daten in Verbindung mit dem unterirdischen Bereich oder durch einen Minifrac-Test bestimmten geologischen Daten umfassen.

14. System nach einem der vorhergehenden Ansprüche 11, 12 oder 13, wobei die Vorgänge ferner Folgendes umfassen:

Komplettieren der Formation des Bohrlochs zu einer spezifizierten Tiefe;
Protokollieren des komplettierten Bohrlochs im Anschluss an das Komplettieren der Formation des Bohrlochs;
Überprüfen der geologischen Daten basierend auf dem Protokollieren des komplettierten Bohrlochs; und
erneutes Kalibrieren des geomechanischen Modells basierend auf den überprüften geologischen Daten; und/oder
wobei der Belastungszustand des unterirdischen Bereichs eine maximale horizontale Belastung des unterirdischen Bereichs umfasst; und optional
wobei das Kalibrieren des geomechanischen Modells basierend auf dem Belastungspolygonverfahren und der UCS in Verbindung mit dem unterirdischen Bereich das Verschieben eines Polygons definiert durch das Belastungspolygonverfahren basierend auf der UCS und einem Reibungskoeffizienten in Verbindung mit dem unterirdischen Bereich umfasst.

15. System nach einem der vorhergehenden Ansprüche 11 bis 14, wobei die Vorgänge ferner das Einstellen eines Gewichts einer Bohrflüssigkeit basierend auf dem vorhergesagten Belastungszustand des unterirdischen Bereichs umfassen; und/oder
wobei die geologischen Daten eines oder mehrere von Gammastrahlendaten, Widerstandsfähigkeitsdaten oder Schalldaten in Verbindung mit dem unterirdischen Bereich umfassen.

**Revendications**

1. Procédé mis en œuvre avec un système comprenant un ordinateur et des moyens pour initier la formation d'un puits de forage et des moyens de diagraphie par câble, pour modéliser des contraintes autour d'un puits de forage, le procédé comprenant :

l'étalonnage d'un modèle géomécanique (130) qui comprend des données géologiques (128) associées à une zone souterraine (116, 118) sur la base d'un procédé de polygone de contraintes et d'une résistance à la compression non confinée (UCS) associés à la zone souterraine ;

la génération d'une sortie d'un état de contrainte prévu de la zone souterraine sur la base du modèle géomécanique étalonné ;

l'initiation de la formation du puits de forage (102) à travers ou à proximité de la zone souterraine, ce qui représente le modèle géomécanique étalonné et l'état de contrainte prévu de la zone souterraine ;

la diagraphie par câble du puits de forage pendant la formation du puits de forage ; et

la révision des données géologiques sur la base de la diagraphie ; et

le réétalonnage du modèle géomécanique sur la base des données géologiques révisées.

2. Procédé selon la revendication 1, comprenant en outre :
la prédiction, pendant la formation du puits de forage, d'un état de contrainte révisé de la zone souterraine en utilisant le modèle géomécanique mis à jour sur la base des données géologiques révisées.

3. Procédé selon les revendications 1 ou 2, comprenant en outre :

la réception d'une identification des données géologiques associées à la zone souterraine ;

la génération, sur la base des données géologiques identifiées, du modèle géomécanique de la zone souterraine ; et, éventuellement,

dans lequel les données géologiques identifiées comprennent au moins les unes parmi des données géologiques historiques associées à la zone souterraine, ou des données géologiques déterminées par un test de minifracturation.

4. Procédé selon l'une quelconque des revendications précédentes, comprenant en outre :

l'achèvement de la formation du puits de forage à une profondeur spécifiée ;

après l'achèvement de la formation du puits de forage, la diagraphie du puits de forage achevé ;

la révision des données géologiques sur la base de la diagraphie du puits de forage achevé ; et

le réétalonnage du modèle géomécanique sur la base des données géologiques révisées ; et/ou,

dans lequel l'état de contrainte de la zone souterraine comprend une contrainte horizontale maximale de la zone souterraine ; et, éventuellement,

dans lequel l'étalonnage du modèle géomécanique sur la base du procédé de polygone de contraintes et de l'UCS associés à la zone souterraine comprend le décalage d'un polygone défini par le procédé de polygone de contraintes sur la base de l'UCS et d'un coefficient de frottement associés à la zone souterraine.

5. Procédé selon l'une quelconque des revendications précédentes, comprenant en outre l'ajustement d'un poids d'un fluide de forage sur la base de l'état de contrainte prévu de la zone souterraine ; et/ou,

dans lequel les données géologiques comprennent les unes ou plusieurs parmi des données de rayons gamma, des données de résistivité ou des données sonores, associées à la zone souterraine.

6. Support de stockage informatique codé avec un programme informatique, le programme comprenant des instructions qui, lorsqu'elles sont exécutées par un système comprenant un ou plusieurs ordinateurs et des moyens pour initier un puits de forage et des moyens de diagraphie par câble, amènent le système à mettre en œuvre des opérations comportant les étapes du procédé selon la revendication 1.

7. Support de stockage informatique selon la revendication 6, dans lequel les opérations comprennent en outre :
la prédiction, pendant la formation du puits de forage, d'un état de contrainte révisé de la zone souterraine en utilisant le modèle géomécanique mis à jour sur la base des données géologiques révisées.

8. Support de stockage informatique selon l'une quelconque des revendications 6 ou 7 précédentes, dans lequel les opérations comprennent en outre :

la réception d'une identification des données géologiques associées à la zone souterraine ;

la génération, sur la base des données géologiques identifiées, du modèle géomécanique de la zone souterraine ; et, éventuellement,

dans lequel les données géologiques identifiées comprennent au moins les unes parmi des données géologiques historiques associées à la zone souterraine, ou des données géologiques déterminées par un test de minifracturation.

9. Support de stockage informatique selon l'une quelconque des revendications 6, 7 ou 8 précédentes, dans lequel les opérations comprennent en outre :

l'achèvement de la formation du puits de forage à une profondeur spécifiée ;
après l'achèvement de la formation du puits de forage, la diagraphie du puits de forage achevé ;
la révision des données géologiques sur la base de la diagraphie du puits de forage achevé ; et
le réétalonnage du modèle géomécanique sur la base des données géologiques révisées ; et/ou,
dans lequel l'état de contrainte de la zone souterraine comprend une contrainte horizontale maximale de la zone souterraine, et, éventuellement,
dans lequel l'étalonnage du modèle géomécanique sur la base du procédé de polygone de contraintes et de l'UCS associés à la zone souterraine comprend le décalage d'un polygone défini par le procédé de polygone de contraintes sur la base de l'UCS et d'un coefficient de frottement associés à la zone souterraine.

10. Support de stockage informatique selon l'une quelconque des revendications 6 à 9 précédentes, dans lequel les opérations comprennent en outre l'ajustement d'un poids d'un fluide de forage sur la base de l'état de contrainte prévu de la zone souterraine ; et/ou,
dans lequel les données géologiques comprennent les unes ou plusieurs parmi des données de rayons gamma, des données de résistivité ou des données sonores, associées à la zone souterraine.

11. Système comprenant un ou plusieurs ordinateurs et des moyens pour initier la formation d'un puits de forage et des moyens de diagraphie par câble, le système étant configuré pour effectuer des opérations comprenant les étapes du procédé selon la revendication 1.

12. Système selon la revendication 11, dans lequel les opérations comprennent en outre :
la prédiction, pendant la formation du puits de forage, d'un état de contrainte révisé de la zone souterraine en utilisant le modèle géomécanique mis à jour sur la base des données géologiques révisées.

13. Système selon l'une quelconque des revendications 11 ou 12 précédentes, dans lequel les opérations comprennent en outre :

la réception d'une identification des données géologiques associées à la zone souterraine ;
la génération, sur la base des données géologiques identifiées, du modèle géomécanique de la zone souterraine ; et, éventuellement,
dans lequel les données géologiques identifiées comprennent au moins les unes parmi des données géologiques historiques associées à la zone souterraine, ou des données géologiques déterminées par un test de minifracturation.

14. Système selon l'une quelconque des revendications 11, 12 ou 13 précédentes, dans lequel les opérations comprennent en outre :

l'achèvement de la formation du puits de forage à une profondeur spécifiée ;
après l'achèvement de la formation du puits de forage, la diagraphie du puits de forage achevé ;
la révision des données géologiques sur la base de la diagraphie du puits de forage achevé ; et
le réétalonnage du modèle géomécanique sur la base des données géologiques révisées ; et/ou,
dans lequel l'état de contrainte de la zone souterraine comprend une contrainte horizontale maximale de la zone souterraine ; et, éventuellement,
dans lequel l'étalonnage du modèle géomécanique sur la base du procédé de polygone de contraintes et de l'UCS associés à la zone souterraine comprend le décalage d'un polygone défini par le procédé de polygone de contraintes sur la base de l'UCS et d'un coefficient de frottement associés à la zone souterraine.

15. Système selon l'une quelconque des revendications 11 à 14 précédentes, dans lequel les opérations comprennent en outre l'ajustement d'un poids d'un fluide de forage sur la base de l'état de contrainte prévu de la zone souterraine ; et/ou,
dans lequel les données géologiques comprennent les unes ou plusieurs parmi des données de rayons gamma, des données de résistivité ou des données sonores, associées à la zone souterraine.

**FIG. 1**

**200**

Uphole

Downhole

202

204

208  206

**FIG. 2A**

FIG. 2B

**250**

**252** — Identify Geologic Data Associated with a Subterranean Zone

**254** — Generate a Geomechanical Model Based on Geologic Data

**256** — Calibrate Model Based on Stress Polygon Method (SPM) and UCS of Subterranean Zone

**258** — Predict Stress State of Subterranean Zone with Calibrated Geomechanical Model

**260** — Initiate Drilling of Wellbore in Subterranean Zone

**262** — Wireline Log to Reveal Formation Properties

**264** — Revise Geologic Data Based on Logging

**266** — Re-calibrate Geomechanical Model Based on Revised Geologic Data

**268** — Predict Stress State of Subterranean Zone with Re-calibrated Geomechanical Model

**270** — Adjust Weight of Drilling Fluid ?

**272** — Adjust Drilling Fluid Weight

Yes / No

**274** — Complete Wellbore Drilling

**276** — Log Completed Wellbore

**278** — Revise Geologic Data Based on Logged Wellbore

**280** — Re-calibrate Geomechanical Model Based on Revised Geologic Data

**282** — Adjust One or More Drilling Parameters Based on Re-calibrated Model

225 —

Geomechanical
Model

230 —

Stress

235 —

Pore
Pressure

240 —

Rock
Strength

Vertical
Stress, and
Horizontal
Stresses,
$(\sigma_v, \sigma_H, \sigma_h)$

Pressures
from Various
Subsurface
Fluids
$(P_f, P_o, P_g, P_w)$

Rock Failure
Stress Under
Various
Confinements
$(UCS, CCS, C_s, \phi)$

**FIG. 2C**

FIG. 3A

FIG. 3B

FIG. 3C

EP 2 850 556 B1

FIG. 4A

FIG. 4B

FIG. 5A

EP 2 850 556 B1

**FIG. 5B**

EP 2 850 556 B1

FIG. 6

FIG. 7A

FIG. 7B

EP 2 850 556 B1

FIG. 8

FIG. 9

EP 2 850 556 B1

FIG. 10A

**FIG. 10B**

**FIG. 11**

EP 2 850 556 B1

FIG. 12

EP 2 850 556 B1

**REFERENCES CITED IN THE DESCRIPTION**

**Patent documents cited in the description**

- US 7181380 B2

**Non-patent literature cited in the description**

- A Method for Evaluating the Effects of Stresses and Rock Strength on Fluid Flow along the Surfaces of Mechanical Discontinuities in Low Permeability Rocks. Milton Bock Enderlin. Texas Christian University, December 2010